# NEUE EUROPÄISCHE PATENTSCHRIFT

(11) **EP 1 812 947 B2**
(45) Veröffentlichungstag und Bekanntmachung des Hinweises auf die Entscheidung über den Einspruch: **10.08.2016**
(45) Hinweis auf die Patenterteilung: 20.03.2013
(21) Anmeldenummer: 05804489.2
(22) Anmeldetag: 25.10.2005
(51) Int. Cl.: H01J 37/317

(54) **MULTISTRAHLMODULATOR FÜR EINEN PARTIKELSTRAHL UND VERWENDUNG DES MULTISTRAHLMODULATORS ZUR MASKENLOSEN SUBSTRATSSTRUKTURIERUNG**
MULTI-BEAM MODULATOR FOR A PARTICLE BEAM AND USE OF THE MULTI-BEAM MODULATOR FOR THE MASKLESS STRUCTURING OF A SUBSTRATE
MODULATEUR MULTIFAISCEAU POUR FAISCEAU DE PARTICULES ET UTILISATION DE CE MODULATEUR POUR TEXTURER UN SUBSTRAT SANS MASQUE

(30) Priorität: 03.11.2004 DE 102004052994
(43) Veröffentlichungstag der Anmeldung: 01.08.2007
(73) Patentinhaber: Vistec Electron Beam GmbH, 07745 Jena (DE)
(72) Erfinder: DÖRING, Hans-Joachim, 07749 Jena (DE); HEINITZ, Joachim, 07751 Isserstedt (DE)
(74) Vertreter: Freitag, Joachim
(86) Internationale Anmeldenummer: PCT/EP2005/055521
(87) Internationale Veröffentlichungsnummer: WO 2006/048391

(56) Entgegenhaltungen:
- US-A- 5 359 202
- US-A- 5 399 872
- US-A- 6 274 877
- US-A1- 2004 149 935
- US-B1- 6 486 480

## Beschreibung

Die Erfindung betrifft einen Multistrahlmodulator für einen Partikelstrahl. Im besonderen betrifft die Erfindung einen Multistrahlmodulator, der aus einem Partikelstrahl mehrere Einzelstrahlen erzeugt, wobei der Partikelstrahl den Multistrahlmodulator zumindest teilweise flächig beleuchtet, der Multistrahlmodulator mehrere Aperturgruppen umfasst und jede Aperturgruppe aus mehreren Aperturzeilengruppen dergestalt aufgebaut ist, dass die GesamtheitallerAperturzeilen eine Matrix aus m x n Zellen aufspannt, wobei m Zellen eine Zeile bilden, und in jeder Zeile k Öffnungen ausgebildet sind.

Ferner betrifft die Erfindung die Verwendung eines Multistrahlmodulators zur maskenlosen Substratstrukturierung. Im besonderen werden durch die Erfindung mehrere Einzelstrahlen erzeugt, indem ein Partikelstrahl den Multistrahlmodulator zumindest teilweise flächig beleuchtet, wobei im Multistrahlmodulator mehrere Apperturgruppen ausgebildet sind, jede Aperturgruppe aus Aperturzeilengruppen besteht und die Gesamtheit der Aperturzeilen eine Matrix aus m x n Zellen aufspannt, wobei m Zellen eine Zeile bilden und in jeder Zeile k Öffnungen ausgebildet sind.

Das U.S. Patent 4,153, 843 offenbart ein Belichtungssystem mit mehreren Strahlen. Dazu ist im Strahlengang eines Elektronenstrahl-Belichtungssystems ein zweidimensionales Array mit mehreren Öffnungen vorgesehen. Das Array wird von dem Elektronenstrahl flächig beleuchtet und verkleinert auf ein Substrat abgebildet. Es ist lediglich eine einzelne Aperturplatte vorgesehen, die aus derflächigen Beleuchtung die mehreren einzelnen Elektronenstrahlen erzeugt. Die einzelnen Öffnungen sind gleichmäßig innerhalb einer Zeile über die Aperturplatte verteilt

Die U.S. Patentanmeldung US 2003/0155534 A1 offenbart ein maskenloses Belichtungssystem für Partikelstrahlen. Eine Vielzahl von hintereinander geschachtelten Aperturplatten erzeugt aus einem Elektronenstrahl eine Vielzahl von Einzelstrahlen. Die obersten zwei Platten und die unterste Platte haben Öffnungen ausgebildet, durch die der Elektronenstrahl durchtritt. Alle Platten haben eine Dicke von ungefähr 100 µm und sind voneinander durch einen Abstand von 100 µm bis 1 mm beabstandet Zwischen der zweiten Platte und der untersten Platte ist ein Array von Korrekturlinsen vorgesehen, das vor der letzten Aperturplatte angeordnet ist. Die Dichte der Öffnungen innerhalb einer Zeile ist konstant.

Das U.S. Patent 5,144,142 offenbart ein Teilchenstrahlsystem, das eine Aperturplatte enthält, um entsprechende Teilstrahlen ausblenden zu können. Die einzige Aperturplatte umfasst m-Reihen und n-Spalten aus Öffnungen, die zweidimensional auf einem Substrat angeordnet sind. Jeder Öffnung ist ein Paar von Ablenkelektroden zugeordnet. Ferner sind n x m-bit-Schieberegister auf dem Substrat vorgesehen, um den Musterdaten entsprechende Spannungen an die m-Paare der Ablenkelektroden zuzuführen. Die Aperturplatte ist jedoch lediglich als einzelnes Bauteil ausgebildet. Es ist ebenfalls keine ungleichmäßige Verteilung der Öffnungen innerhalb einer Zeile vorgeschlagen.

Das U.S. Patent 5,369,282 offenbart ein Teilchenstrahlsystem, das aus einem flächigen Elektronenstrahl mit Hilfe einer Aperturplatte eine Vielzahl von Teilstrahlen erzeugt, die auf ein Substrat abgebildet werden. Eine Vielzahl von Öffnungen ist in der Aperturplatte ausgebildet. Die Öffnungen sind gleichmäßig über der Aperturplatte verteilt.

Das U.S. Patent 5,430,304 offenbart ein Teilchenstrahlsystem, mit dem eine Vielzahl von Teilstrahlen auf ein Substrat abgebildet wird. Es ist ebenfalls eine Aperturplatte vorgesehen, in der eine Vielzahl von schaltbaren Öffnungen ausgebildet ist. Die Öffnungen werden über eine entsprechende Anzahl von Schieberegistern angesteuert. Die Verteilung der Öffnungen in der Aperturplatte ist homogen.

Der Artikel "Programmable Aperture Plate for Maskless High-Throughput Nanolithography" von Berry et al.; J. Vac. Sci. Technol. B 15(6), Nov/Dec 1997; Seite 2382 bis 2386, offenbart ein programmierbares Aperturenarray, das 3000 x 3000 Aperturen umfasst, die individuell elektronisch angesteuert beziehungsweise aktiviert werden können, um dadurch den Strahldurchtritt zu kontrollieren oder zu steuern. Das zu schreibende Muster wird von einer Seite in das Aperturplattensystem als binäres Bildsignal eingeleitet und zu der anderen Seite durchgeschoben. Das Aperturplattensystem umfasst eine Aperturplatte mit den entsprechenden Ablenkelektroden, wobei die Öffnungen entsprechend regelmäßig verteilt sind.

Aus den obigen Publikationen sind Multistrahlmodulatoren in Form von Zeilen bzw. Arrays bekannt, bei denen die Ansteuerung jedes Steuerelementes separat erfolgt, was jedoch auf Grund der großen Anzahl von Zuleitungen die Zahl der parallel arbeitenden Strahlen auf ca. 1000 begrenzt und trotz des vielfachen Aufwandes nur einen mäßigen Produktivitätszuwachs ermöglicht.

Im weiteren wurden deshalb regelmäßige bzw. gleichmäßige Arraystrukturen mit n Zeilen und m Spalten vorgeschlagen, in denen die Information Ein/Aus in jeder Zeile von einem der m Modulatorelemente zum nächsten über integrierte Verzögerungsglieder oder Schieberegister weitergegeben wird. Das zeitliche Shiften des Pixelbildes von Spalte zu Spalte wird mit einer Scanbewegung aller Strahlen relativ zum Substrat korreliert, so dass es gelingt, alle nxm Strahlen parallel zu nutzen, wobei mit jedem Belichtungstakt jedoch nur neue Daten für die n Modulatoren der ersten Spalte bereitgestellt werden müssen. Hauptmangel bekannter Realisierungen dieses Prinzips ist die Beschränkung auf ein Bit (Ein/Aus) pro Belichtungstakt und Zeile, wodurch zwingend erforderliche Dosisstufen, Proximitykorrekturen u.ä. nur in begrenztem Umfang durch Verwendung mehrerer Arrays realisiert werden können. Bekannte Lösungen für den Blanking Chip benötigen eine hohe Speicherdichte und sind unflexibel.

Der Erfindung liegt die Aufgabe zugrunde, Multistrahlmodulatoren für einen Partikelstrahl zur maskenlosen Übertragung eines Layouts auf ein Substrat zu schaffen, die direkt elektronisch angesteuert werden können, und wobei der Multistrahlmodulator sowohl hinsichtlich des minimalen Speicherbedarfs der elektronischen Schaltung, als auch der zeitlichen und räumlichen Homogenisierung des Gesamtstrahls sowie strahloptischer Gesichtspunkte konfigurierbar ist.

Diese Aufgabe wird durch einen Multistrahlmodulator mit den Merkmalen des Anspruchs 1 gelöst.

Eine weitere Aufgabe der Erfindung ist die Verwendung des Multistrahlmodulators zur maskenlosen Substratstrukturierung, wobei der Multistrahlmodulator sowohl hinsichtlich des minimalen Speicherbedarfs der elektronischen Schaltung, als auch der zeitlichen und räumlichen Homogenisierung des Gesamtstrahls sowie strahloptischer Gesichtspunkte konfigurierbar ist.

Diese Aufgabe wird durch die Verwendung eines Multistrahlmodulators mit den Merkmalen des Anspruchs 21 gelöst.

Die Erfindung hat den Vorteil, dass dadurch die aufwändigen und kostenintensiven Schritte der Herstellung von Belichtungsmasken vermieden werden. Das zeitlich serielle Schreibprinzip bedingt jedoch eine gegenüber der parallelen Strukturübertragung mittels Maskeverringerte Produktivitätder Belichtung. Eine Entwicklungsrichtung maskenloser Belichtungsgeräte besteht deshalb darin, durch eine große Anzahl parallel arbeitender Teilstrahlen die effektive Schreibgeschwindigkeit zu vervielfachen. Die Teilstrahlen sind dabei in Form eines Arrays angeordnet und können durch ein spezielles Modulationselement (steuerbare Strahlquellen / Blanker / Spiegel) einzeln ein- und ausgeschaltet werden. Der vorliegende Erfindungsvorschlag beschreibtden Aufbau eines Multistrahlmodulators auf der Basis von zeilenorientierten Schieberegistern und dessen Konzept der Dosissteuerung. Dabei kann der Multistrahlmodulator sowohl hinsichtlich minimalen Speicherbedarfs der elektronischen Schaltung, als auch der zeitlichen und räumlichen Homogenisierung des Gesamtstrahls sowie strahloptischer und thermischer Gesichtspunkte konfiguriert werden. Im weiteren beinhaltet er Lösungsvorschläge, wie mittels Rekonfigurierbarkeit der Steuerung eine Fehlerredundanz und Dosiskorrektur ermöglicht wird.

Der Multistrahlmodulator hat den Vorteil, dass die Dichte der Öffnungen innerhalb einer Zeile ungleichmäßig verteilt ist. Dadurch werden somit Extrema in dem Gesamtstrom aller Teilstrahlen vermieden. Die Öffnungen innerhalb einer Zeile sind gleich beabstandet, wobei aber der Abstand zwischen den Öffnungen, ausgedrückt in einer Anzahl von Zellen, kleiner ist als der Quotient aus der Zahl der Zellen einer Zeile und der Zahl der Öffnungen innerhalb einer Zeile.

Es ist von Vorteil, wenn die Zahl kder Öffnungen innerhalb einer Zeile zwischen 64 und 71 beträgt bzw. einem Vielfachen davon. Die Zellen des Multistrahlmodulators besitzen eine quadratische Form und die Größe der Zellen entspricht einem am Target zu schreibenden Pixel multipliziert mit dem Abbildungsmaßstab der nachgeschalteten Optik. Alle Öffnungen einer Zeile nebst dazwischenliegender Zellen bilden eine Aperturzeile. Mehrere Aperturzeilen, die im gleichen X-Intervall und einem gewählten Y-Intervall liegen, sind zu Aperturzeilengruppen zusammengefasst. Ebenso sind die Aperturzeilengruppen zu Aperturgruppen zusammengefasst und regelmäßig auf einem Chip einer Aperturplatte angeordnet. Die Aperturgruppen sind durch Stege getrennt, auf denen keine Strukturierung vorgenommen ist.

Weitere vorteilhafte Ausgestaltungen der Erfindung können den Unteransprüchen entnommen werden.

In der Zeichnung ist der Erfindungsgegenstand schematisch dargestellt und wird anhand der Figuren nachfolgend beschrieben. Dabei zeigen:
- Fig. 1: eine Darstellung einer Aperturplatte gemäß dem Stand der Technik;
- Fig. 2: eine schematische Darstellung des Aufbaus eines gesamten Systems zur Elektronenstrahllithographie ;
- Fig. 3: eine schematische Darstellung der Vorrichtung zur Strukturierung eines Partikelstrahls;
- Fig. 4: eine erste Ausführungsform der Aperturplatte gemäß der Erfindung, wobei die Öffnungen in der Apertuplatte nach dem erfindungsgemäßen System verteilt sind;
- Fig. 5: eine zweite Ausführungsform der Aperturplatte, wobei die Öffnungen in der Aperturplatte nach dem erfindungsgemäßen System verteilt sind;
- Fig.6: eine schematische Ansicht einer aktiven Aperturplatte gemäß einer Ausführungsform, wobei die Aperturgruppen auf einem Chip konfiguriert sind;
- Fig.7: eine schematische Ansicht einer aktiven Aperturplatte gemäß einer weiteren Ausführungsform, wobei die Aperturgruppen auf einem Chip konfiguriert sind;
- Fig. 8: eine schematische Ansicht einer aktiven Aperturplatte gemäß einer weiteren Ausführungsform, wobei die Aperturgruppen auf einem Chip konfiguriert sind;
- Fig. 9: eine schematische Ansicht einer aktiven Aperturplatte gemäß einer weiteren Ausführungsform, wobei die Aperturgruppen auf einem Chip konfiguriert sind;
- Fig. 10: eine schematische Ansicht einer aktiven Aperturplatte gemäß einer weiteren Ausführungsform, wobei die Aperturgruppen auf einem Chip konfiguriert sind;
- Fig. 11: eine schematische Ansicht einer aktiven Aperturplatte gemäß einer weiteren Ausführungsform, wobei die Aperturgruppen auf einem Chip konfiguriert sind;
- Fig. 12: eine schematische Ansicht einer aktiven Aperturplatte gemäß einer weiteren Ausführungsform, wobei die Aperturgruppen auf einem Chip konfiguriert sind;
- Fig. 13: eine Anordnung der Schieberegister auf der erfindungsgemäßen aktiven Aperturplatte;
- Fig. 14: einen Vorschlag, bei dem jedem Modulatorelement eine kombinatorische Logikschaltung zugeordnet ist;
- Fig. 15: einen Vorschlag, bei dem die Modulatorelemente durch eine konfigurierbare Logik angesteuert werden; und
- Fig. 16: eine Modifikation der Geometrie der Öffnungen in der Aperturplatte.

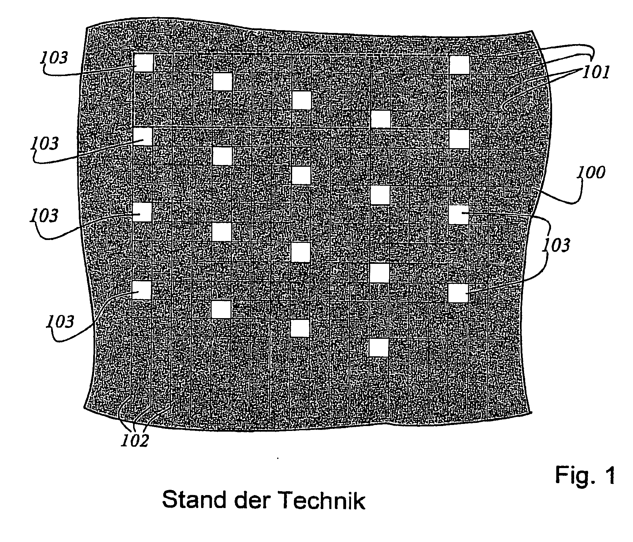

Figur 1 ist eine Darstellung einer Aperturplatte 100 gemäß dem Stand der Technik. In der Aperturplatte 100 sind n Zeilen 101 mit m Zellen und m Spalten 102 mit n Zellen ausgebildet. In jeder Zeile 101 ist eine bestimmte Anzahl k Öffnungen 103 ausgebildet. Die Öffnungen 103 sind innerhalb einer Zeile 101 derartverteilt, dass die Dichte der Öffnungen 103 innerhalb einer Zeile 101 gleich ist.

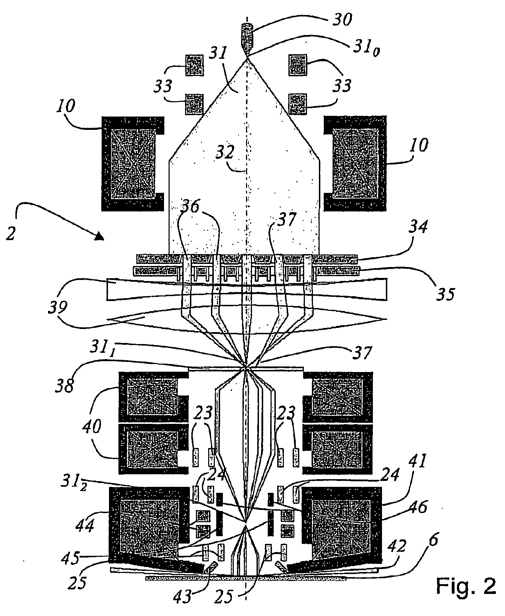

Figur 2 zeigt schematisch den Aufbau eines gesamten Systems zur maskenlosen Elektronenstrahllithographie. Obwohl sich die nachfolgende Beschreibung auf Elektronenstrahlen beschränkt, soll dies nicht als eine Beschränkung der Erfindung aufgefasst werden. Es ist selbstverständlich, dass die Erfindung für alle Partikelstrahlen geeignet ist.

Von einer Elektronenkanone 30 wird ein Elektronenstrahl 31 erzeugt, der sich in Richtung einer elektronenoptischen Achse 32 ausbreitet. Die aus der Elektronenkanone 30 austretenden Elektronen weisen einen Quell-Crossover 31₀ auf. Der Elektronenkanone 30 ist eine Strahlzentriereinrichtung 33 nachgeschaltet, die den Elektronenstrahl symmetrisch um die optische Achse 32 ausrichtet. Nach der Strahlzentriereinrichtung durchläuftder Elektronenstrahl 31 ein Kondensorsystem 10, das ausdem anfänglich divergenten Elektronenstrahl 31 einen parallelen Strahl formt. Der durch das Kondensorsystem 10 geformte Strahl besitzt einen Durchmesser, über den die Intensität homogen verteilt ist. Nach dem Kondensorsystem 10 ist ein flächiges Objekt 34 vorgesehen. Das flächige Objekt 34 ist eine Aperturplatte bzw. ein Apertuplattensystem 50. Das Aperturplattensystem 50 ist mit einer Vielzahl von Öffnungen zur Erzeugung vieler paralleler Strahlenbündel 36 versehen. In Ausbreitungsrichtung der Strahlenbündel 36 hin zum Target 6 folgt eine Ablenkplatte 35, die eine Vielzahl von Strahlablenkeinheiten besitzt. Nach der Ablenkplatte 35 folgt eine Beschleunigungslinse 39, die die Energie der Elektronen im Elektronenstrahl 31 erhöht und dann ein erstes Zwischenbild des Crossovers 31₁ am Ort der Aperturblende 38 erzeugt. Alle individuellen CrassoverderTeilstrahlenbündel 36 entstehen nahezu am gleichen Ort, nämlich der Blendenöffnung der Aperturblende 38. Der Durchmesser der Öffnung der Aperturblende 38 ist dabei so gewählt, dass nahezu alle Elektronen der unabgelenkten Strahlenbündeln 36 die Aperturblende 38 passieren können. Einzelstrahlen 37, die durch die Ablenkplatte 35 eine individuelle Richtungsänderung erfahren haben, werden an der Aperturblende 38 gestoppt, da ihr Crossover-Zwischenbild nicht am Ort der Aperturblendenöffnung entsteht. Im weiteren Strahlverlauf folgt jetzt mindestens eine magnetische Linse 40 zwecks verkleinerter Abbildung der Aperturplatte 34 auf das Target 6. In dem hier dargestellten Ausführungsbeispiel sind zwei magnetische Linsen 40 gezeigt. Bei der Abbildung entsteht ein zweites Zwischenbild des Crossovers 31₂. Bevor die unabgelenkten Strahlenbündel 36 auf das Target 6 treffen, das zum Beispiel ein Wafer ist, durchlaufen sie eine Objektivlinse 41. Die Objektivlinse 41 ist mit einer Vielzahl von Elementen ausgestattet. Vor und nach einem zweiten Crossover 31₂ des Elektronenstrahls 31 sind zwei Ablenkeinrichtungen 45 und 46 vorgesehen. Die Ablenkeinrichtungen 45 und 46 dienen zum Auslenken und zur Lagebestimmung des Elektronenstrahls 31 beziehungsweise der Vielzahl der unabgelenkten Strahlenbündel 36 im Target 6. Die zwei unabhängig steuerbaren Ablenksysteme 45 und 46 werden vorteilhaft dazu benutzt, um langsame und schnelle Ablenkvorgänge separat optimal zu gestalten. Schnelle Ablenkvorgänge im Frequenzgebiet Megahertz bis Gigahertz sind zum Beispiel erforderlich, um mittels sägezahnförmiger Ablenkungen die Position der verkleinerten Aperturplatte 34 auf dem gleichförmig bewegten Target 6 für die Zeitdauer eines Belichtungsschrittes beziehungsweise Belichtungstaktes konstant zu halten und anschließend in sehr kurzer Zeit zum nächsten Belichtungspunkt zu springen. Da benachbarte Pixel typisch kleinerals 100 Mikrometer entfernt sind, wird das schnelle Ablenksystem 46 bevorzugt als elektrostatisches System aufgebaut. Für die Kompensation niederfrequenter Positionsabweichungen des Targets 6 von der gleichförmigen Bewegung im Bereich von einigen Mikrometern kommt bevorzugt ein langsames aber hochgenaues magnetisches Ablenksystem 45 zum Einsatz. Ferner sind Stigmatoren 44 vorgesehen, die bevorzugt als mehretagige magnetische Spulensysteme aufgebaut sind, um Astigmatismen und Verzeichnungen, die in der optischen Säule durch Fertigungstoleranzen und Justagefehler bedingt sind, auszugleichen. Die Objektivlinse 41 besitzt ein am Landepunkt des Elektronenstrahls am Target 6 abtastendes Höhenmesssystem 42. Das Höhenmesssystem 42 dient der Erfassung von Unebenheiten des Targets 6 (zum Beispiel Wafer) sowie von Höhenschwankungen, die ein Verschiebetisch verursachen kann. Ein Detektor 43 für die von Target 6 rückgestreuten Partikel beziehungsweise Elektronen befindet sich nahe dem Strahlauftreffpunkt. Dieser Detektor 43 dient der Positionsermittlung von Marken auf dem Target 6 zum Zwecke der Überdeckung mehrerer Belichtungsebenen beziehungsweise zur Kalibrierung von Steuerelemente einer Belichtungsanlage. Weiterhin befinden sich drei Korrekturlinsenpaare 23, 24, 25 im unteren Bereich der Korpuskularstrahleinrichtung 2. Die Korrekturlinsen 23, 24, 25 dienen der dynamischen Korrektur des Fokus, der Bildfeldgröße und der Bildfeldrotation während der Belichtung des kontinuierlich bewegten Targets 6. Das Korrekturlinsensystem 23, 24, 25 ermöglicht die Korrektur von Fehlern, die durch Höhenschwankungen des Targets 6, sowie durch veränderliche Raumladungen im Säulenbereich hervorgerufen werden.

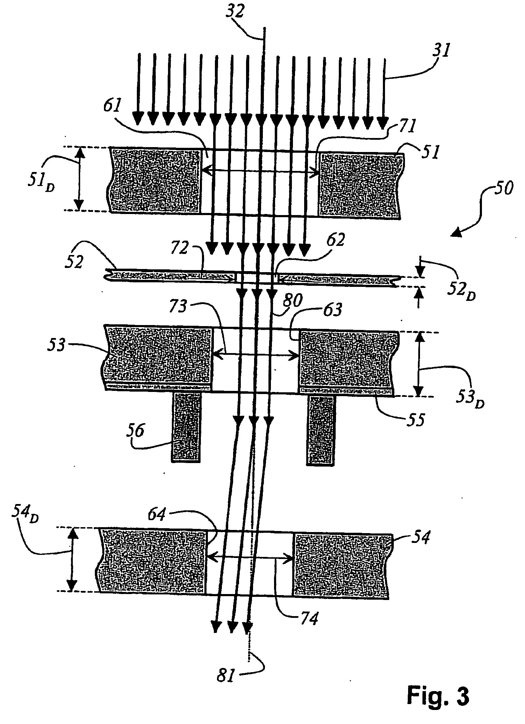

Figur 3 zeigt eine schematische Darstellung einer Vorrichtung 50 zur Strukturierung eines Partikelstrahls 31. Es sei bemerkt, dass der Partikelstrahl 31 mit einem Elektronenstrahl gleichzusetzen ist. Die Vorrichtung 50 zur Strukturierung des Partikelstrahls 31 besteht aus einer ersten Aperturplatte 51, einer zweiten Aperturplatte 52, einer dritten Aperturplatte 53 und einer vierten Aperturplatte 54. Der in Richtung der optischen Achse 32 einfallende Partikelstrahl beleuchtet großflächig die erste Aperturplatte 51. In der ersten Aperturplatte 51 sind eine Vielzahl von Öffnungen 61 ausgebildet, die einen im wesentlichen quadratischen Querschnitt besitzen. Die erste Aperturplatte 51 besteht aus Silizium und besitzt eine Dicke 51_{D} von circa 20µm bis 100 µm. Der ersten Aperturplatte 51 ist eine zweite Aperturplatte 52 nachgeschaltet. In der zweiten Aperturplatte sind ebenfalls Öffnungen 62 ausgebildet. Der zweiten Aperturplatte 52 ist eine dritte Aperturplatte 53 nachgeschaltet, in der ebenfalls mehrere Öffnungen 63 ausgebildet sind. Der dritten Aperturplatte 53 ist eine vierte Aperturplatte 54 nachgeschaltet, in der ebenfalls mehrere Öffnungen 64 ausgebildet sind. Alle Öffnungen 61, 62, 63, 64 in der ersten Aperturplatte 51, in der zweiten Aperturplatte 52, in der dritten Aperturplatte 53 und in der vierten Aperturplatte 54 haben einen quadratischen Querschnitt. Die Öffnung 61 in der ersten Aperturplatte besitzt eine größere Abmessung 71 als die Öffnung 62 in der zweiten Aperturplatte 52. Diederersten Aperturplatte 51 nachgeschaltete Aperturplatte 52 besitzt dabei eine Dicke 52_{D} von wenigen Mikrometern und die Öffnungen 62 besitzen einen hochgenauen quadratischen Querschnitt. Hochgenau bedeutet in diesem Zusammenhang, dass der Querschnitt eine Toleranz < 100nm für die absolute Maßhaltigkeit in x und y einhält und ebenso die Eckenradien sowie die Kantenrauhigkeit eine Toleranz < 100nm erfüllen. Die Öffnungen 62 in der zweiten Aperturplatte 52 besitzen eine Abmessung 72, die kleiner ist als die Abmessung 71 der Öffnung 61 in der ersten Aperturplatte 51. Ein typisches Verhältnis für die Abmessungen der Öffnungen 71 : 72 beträgt 2...3, wenn man absolute Maße von 6...3µm für die Öffnung 62 unterstellt. Die erste Aperturplatte 51 wird, wie bereits erwähnt, flächig vom einfallenden Elektronenstrahl 31 beleuchtet und erzeugt dabei durch die Öffnungen 61 mehrere Teilstrahlen, die im Querschnitt dem Querschnitt der Öffnungen 61 in der ersten Aperturplatte 51 entsprechen. Die erste Aperturplatte 51 dient nicht nur zur Erzeugung einer Vielzahl von Teilstrahlen, sondern dient auch dazu, die vom einfallenden Elektronenstrahl 31 erzeugte überschüssige Wärme abzuleiten. Die durch die erste Aperturplatte 51 erzeugten Teilstrahlen treffen auf die zweite Aperturplatte 52, wobei die Öffnungen 62 in der zweiten Aperturplatte 52 den für die Abbildung erforderlichen formdefinierten Teilstrahl 80 erzeugen. Der formdefinierte Teilstrahl 80 trifft auf die dritte Aperturplatte 53, in der Öffnungen 63 ausgebildet sind, die ebenfalls eine größere Abmessung 73 aufweisen als die Öffnungen 62 in der zweiten Aperturplatte 52. Die dritte Aperturplatte 53 weist auf der dem einfallenden Partikelstrahl 31 abgewandten Seite eine Ansteuerschaltung 55 auf, die die für die Ablenkung des formdefinierten Teilstrahl 80 erforderlichen Signale erzeugt. Die dritte Aperturplatte 53 besitzt eine Dicke 53_{D} von circa 20 µm bis 100 µm. Die vierte Aperturplatte 54 besitzt eine Dicke 54_{D} von circa 20 µm bis 100 µm.

Ebenso ist an der dem einfallenden Partikelstrahl 31 abgewandten Seite der dritten Aperturplatte 53 jede Öffnung 63 ein Deflektor 56 für den formdefinierten Teilstrahl 80 zugeordnet. Der dritten Aperturplatte 53 ist eine vierte Aperturplatte 54 nachgeschaltet, in der ebenso Öffnungen 64 vorgesehen sind, die in etwa die gleiche Abmessung 74 aufweisen wie die Öffnungen 63 in der dritten Aperturplatte 53. Die erste Aperturplatte 51, die zweite Aperturplatte 52, die dritte Aperturplatte 53 und die vierte Aperturplatte 54 sind zueinander derart angeordnet, dass alle Öffnungen 61, 62, 63, 64 entlang einer Zentrumsachse 81 ausgerichtet sind.

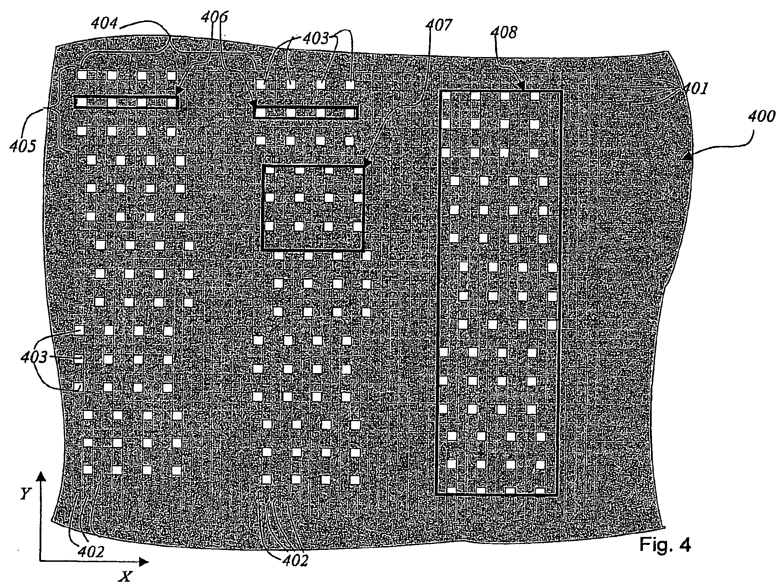

Figur 4 zeigt eine erste Ausführungsform der Aperturplatte 400 gemäß der Erfindung. Die Öffnungen 403 in der Aperturplatte 400 sind nach dem erfindungsgemäßen System verteilt. In der Aperturplatte 400 sind n Zeilen 401 mit m Zellen und m Spalten 402 mit n Zellen ausgebildet. In jeder Zeile 401 ist eine bestimmte Anzahl k Öffnungen 403 ausgebildet. Die Öffnungen 403 sind innerhalb einer Zeile 401 derart verteilt, dass die Dichte der Öffnungen 403 innerhalb einer Zeile 401 ungleichmäßig verteilt ist. In dem hier dargestellten Ausführungsbeispiel sind die Öffnungen 403 innerhalb einer Zeile 401 derartgruppiert, dass der Abstand zwischen den Öffnungen 403 in einer Zeile 401 zwei Zellen beträgt. Die Zahl der Öffnungen 403 in einer Zeile 401 und der darin gebildeten Aperturzeile 406 ist vier. Dabei ist die Zahl der Zellen innerhalb einer Zeile 401 um den Faktor mindestens zehn größer als die Zahl der Öffnungen 403. Die vier Öffnungen 403 sind in der Zeile 401 derart verteilt, dass jede dritte Zelle innerhalb der Aperturzeile 406 eine Öffnung 403 ist Der Aperturzeilenversatz 404 beträgt achtzehn Zellen in X-Richtung, d.h., dass jeweils zwei in X-Richtung nebeneinander liegende Aperturzeilen 406 um achtzehn Zellen versetzt sind. Eine Aperturzeilensubgruppe 407 umfasst drei Aperturzeilen 406. Aperturzeilengruppen 408 werden durch eine Vielzahl von in Y-Richtung aneinander grenzender Aperturzeilensubgruppen 407 gebildet. In X-Richtung benachbarte Aperturzeilen 406 gehören stets zu verschiedenen Aperturzeilengruppen 408 und besitzen einen Y-Versatz von wenigstens einer Zelle 401.

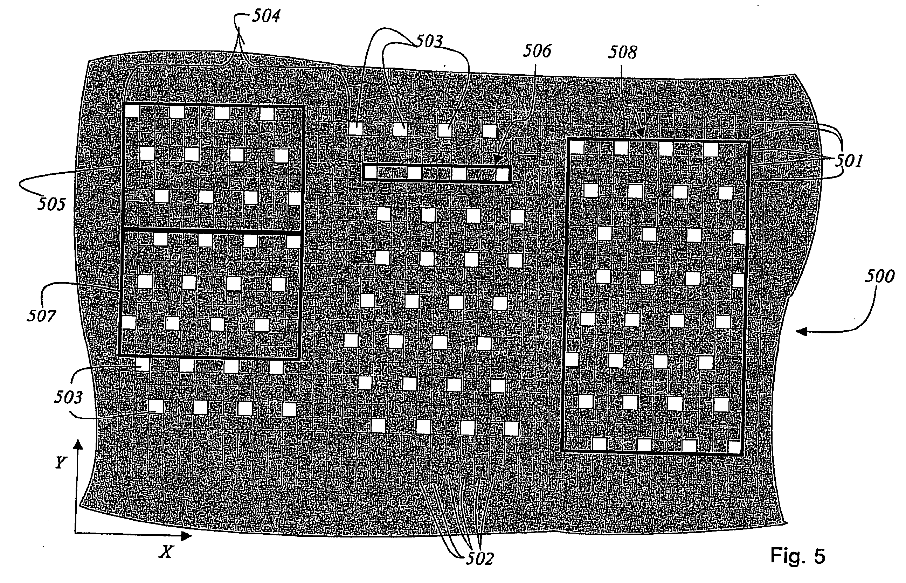

Figur 5 zeigt eine zweite Ausführungsform der Aperturplatte 500 gemäß der Erfindung. Die Öffnungen 503 in der Aperturplatte 500 sind nach dem erfindungsgemäßen System verteilt. In der Aperturplatte 500 sind n Zeilen 501 mit m Zellen und m Spalten 502 mit n Zellen ausgebildet. In jeder Zeile 501 ist eine bestimmte Anzahl k Öffnungen 503 ausgebildet. Die Öffnungen 503 sind innerhalb einer Zeile 501 derart verteilt, dass die Dichte der Öffnungen 503 innerhalb einer Zeile 501 ungleichmäßig verteilt ist. In dem hierdargestellten Ausführungsbeispiel sind die Öffnungen 503 innerhalb einer Zeile 501 derart gruppiert, dass der Abstand zwischen den Öffnungen 503 in einer Zeile 501 innerhalb der Aperturzeile 506 zwei Zellen beträgt. Die Zahl der Öffnungen 503 in einer Zeile 501 ist vier. Dabei ist die Zahl der Zellen innerhalb einer Zeile 501 um den Faktor mindestens zehn größer als die Zahl der Öffnungen 503. Die vier Öffnungen 503 sind in jeder Zeile 501 derart verteilt, dass innerhalb der Aperturzeile 506 jede dritte Zelle eine Öffnung 503 ist. Der Aperturzeilenversatz 504 beträgt in X-Richtung fünfzehn Zellen, d.h., dass jeweils zwei benachbarte Aperturzeilensubgruppen 505, 507 um fünfzehn Zellen in X-Richtung versetzt sind. In dem hier dargestellten Ausführungsbeispiel wechseln eine erste Aperturzeilensubgruppe 505 und eine zweite Apertuzeilensubgruppe 507 einander ab. Sowohl die erste als auch die zweite Aperturzeilensubgruppe 505 und 507 umfasst drei Aperturzeilen 506. Die erste Aperturzeilensubgruppe 505 ist dabei derart ausgestaltet, dass die erste Zeile 501 der ersten Aperturzeilensubgruppe 505 mit einer Öffnung 503 beginnt. Die zweite Aperturzeilensubgruppe 507 ist dabei derart gestaltet, dass die erste Zeile 501 bei der dritten Zelle mit einer Öffnung 503 beginnt.

Die oben erläuterten Realisierungsvarianten sind auf der Basis der vorgeschlagenen Verteilung der Öffnungen 403, 503 folglich auch der Modulatorelemente vorgeschlagen, wobei alle k Modulatorelemente jeder Zeile 401,501 in möglichst geringem Abstand von p-mal der Teilstrahlbreite (p = 4...8) direkt hintereinander angeordnet sind und sich dadurch die geringst mögliche Aperturzeilenlänge ergibt. Jeweils p Aperturzeilengruppen sind in X-Richtung versetzt angeordnet, wobei der Versatz einem ganzzahligen Vielfachen der Teilstrahlbreite entspricht und größer als die Aperturzeilenlänge ist. Durch wiederholte, orthogonal zur Zeilenrichtung versetzte Anordnung von Aperturzeilensubgruppen 407 bzw. 505, 507 entstehen Aperturzeilengruppen 408, 508 , die das komplette Blendenarray bilden (siehe Fig. 4 und 5).

Da die Dosisinformationen jeweils nur in verkürzten Zeilen, nämlich den Aperturzeilen 406, 506 gehalten werden müssen, ergibt sich eine Verringerung der Gesamtspeicherdichte um den Faktor p. Außerdem verringern sich durch die engere Nachbarschaft aller Öffnungen 403, 503 und folglich auch der Modulatorelemente in jeder Zeile 401,501, die Unschärfe für ein bestimmtes Pixel auf dem Substrat, die durch Überlagerung der unterschiedlichen Verzeichnungen entsteht, die die einzelnen Aperturen einer Aperturzeile 406, 506 bei der Abbildung auf das Target erleiden. Weiterhin ergibt sich die Möglichkeit der Korrektur von Verzeichnungsrestfehlern, die z.B. fertigungsbedingt sein können und ermittelt wurden, was sich ebenso in einer verbesserten lithographischen Auflösung niederschlägt.

Herzstück der vorgeschlagenen Vorrichtung 50 ist das Aperturplattensystem, wobei bei mindestens einer aktiven Aperturplatte 53 den Öffnungen 403, 503 Deflektoren oder Modulatorelemente (siehe Figur 3) zugeordnet sind. Die Erfindung benutzt dabei kein vorgegebenes, regelmäßiges Array von Öffnungen 403, 503 bzw. von Deflektoren. Die Dichte der Öffnungen 403, 503 innerhalb einer Zeile 401, 501 ist nicht gleichmäßig über die Zeile 401, 501 verteilt. Die Deflektoren oder Modulatorelemente umfassen n Schieberegister der Länge m. Dies ergibteinen, von den verschiedenen physikalischen und technologischen Randbedingungen abhängenden, Multistrahlmodulator.

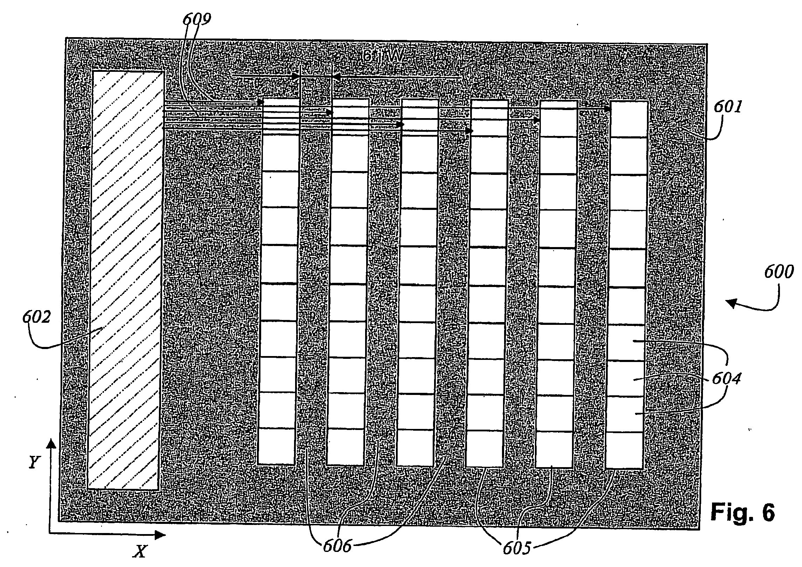

Figur 6 zeigt eine schematische Ansicht einer kompletten aktiven Aperturplatte 600 gemäß einer Ausführungsform. Die Größe eines Chips 601, auf dem die Aperturplatte 600 realisiert ist, beträgt 33 mm x 26 mm. Auf dem Chip 601 ist ebenfalls eine Steuerelektronik 602 realisiert. Auf der Aperturplatte 600 sind die Aperturzeilengruppen 604, die in einer X- Linie 605 angeordnet sind, durch Stege 606 voneinander getrennt. In den Stegen 606 ist keine Strukturierung durch Aperturzeilengruppen 604 vorgenommen. Die sechs Aperturzeilengruppen 604 in jeder X-Linie 605 besitzen untereinander einen Y-Versatzvon 1 bis 5 Zellen, so dass die Öffnungen der Aperturzeilen jeder Aperturzeilengruppe 604 in unterschiedlichen Zeilen positioniert sind. Bei dem in Fig. 6 dargestellten Ausführungsbeispiel istdie Zahl k der Öffnungen in jeder Aperturzeile gleich 64. Der Abstand zwischen zwei Öffnungen innerhalb einer Zeile beträgt fünf Zellen, bzw. der Pitchabstand p ist gleich 6. Der Aperturzeilenversatz in X-Richtung X kann z. B. *X* = *384W* + *6* × *j* × *W* sein. Dabei ist 6 x *j* x *W* die Breite der Stege 606 zwischen den in einer Linie angeordneten Aperturzeilengruppen 605. W steht für die Abmessung der Öffnungen bzw. Zellen und j ist eine ganze Zahl. Eine Aperturzeilengruppe 604 kann z.B. 64 Aperturzeilen umfassen, die in Y-Richtung jeweils um 6 *W* versetzt sind. Alle 60 dargestellten Aperturzeilengruppen 604 zusammen beinhalten somit 3840 Aperturzeilen mit jeweils 64 Öffnungen. Aus Gründen der Datenübertragungseffektivität kann es sinnvoll sein, die Anzahl der Aperturzeilen z.B. auf 4096 zu erweitern, was durch Anordnung weiterer Aperturzeilengruppen bzw. durch Erhöhung der Anzahl der Aperturzeilen pro Aperturzeilengruppe 604 erfolgen kann. Symbolisch angedeutete elektrische Leitungen 609 verbinden die Steuerelektronik 602 mit jeweiligen ersten Schieberegistern jeder Aperturzeile, die die Grauwertinformation dann getaktet von Zelle zu Zelle durch die Aperturzeile schiebt.

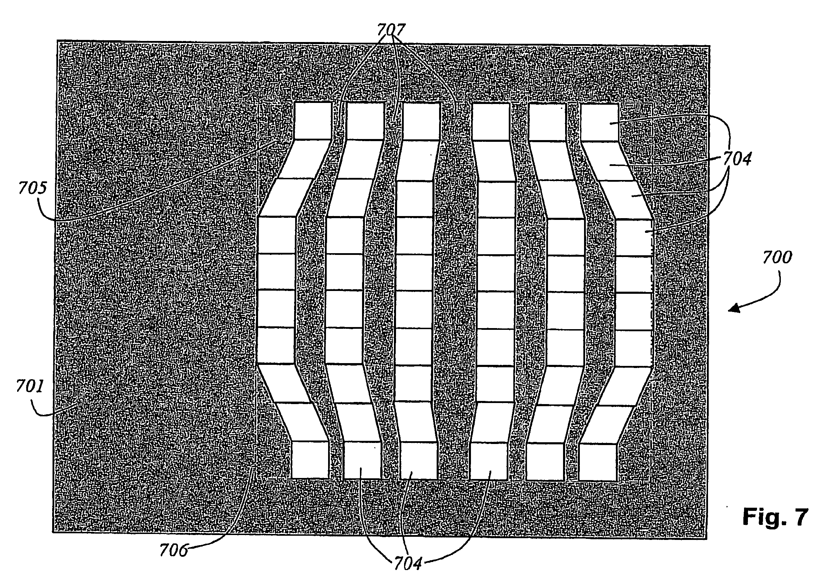

Figur 7 zeigt eine schematische Ansicht einer kompletten aktiven Aperturplatte 700 gemäß einer weiteren Ausführungsform. Die Größe eines Chips 701, auf dem die Aperturplatte 700 realisiert ist, beträgt 33 mm x 26 mm. Auf dem Chip 701 ist analog zu Fig. 6 eine Steuerelektronik (nicht dargestellt) realisiert. Auf dem Chip 701 der Aperturplatte 700 sind die einzelnen Aperturzeilengruppen 704 derart angeordnet, dass sich der Abstand 707zwischen den einzelnen Aperturzeilengruppen 704 in den Eckbereichen 705 eines um die Anordnung der einzelnen Aperturzeilengruppen 704 gezogenen Rechtecks 706 verringert. In den Abständen 707 zwischen den Aperturzeilengruppen 704 ist keine Strukturierung durch Aperturzeilengruppen 704 vorgenommen. Bei dem in Figur 7 dargestellten Ausführungsbeispiel, ist die Zahl k der Öffnungen in jeder Aperturzeile gleich 64. Der Abstand zwischen zwei Öffnungen innerhalb einer Zeile beträgt fünf Zellen, bzw. der Pitchabstand p ist gleich 6. Der Aperturzeilenversatz in X-Richtung X kann z.B. *X*=384*W*+6×*j*×*W* sein. Dabei ist 6 × *j* × *W* der maximale Abstand 707 zwischen den aneinandergereihten Aperturzeilengruppen 704. Eine Aperturzeilengruppe 704 kann z.B. 64 Aperturzeilen umfassen, die in Y-Richtung jeweils um 6 W versetzt sind. Alle dargestellten sechzig Aperturzeilengruppen 704 zusammen beinhalten somit 3840 Aperturzeilen mit jeweils 64 Öffnungen.

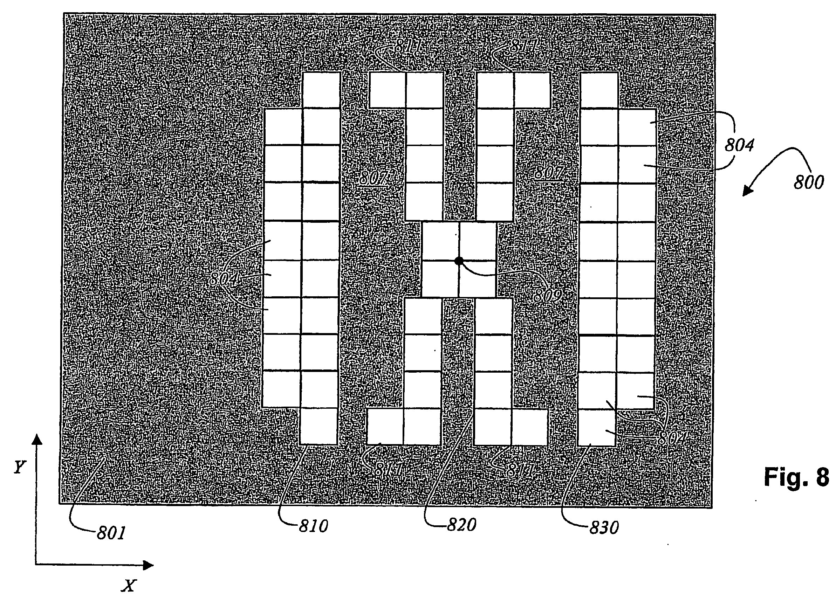

Figur 8 zeigt eine schematische Ansicht einer kompletten aktiven Aperturplatte 800 gemäß einer weiteren Ausführungsform. Die Größe eines Chips 801, auf dem die Aperturplatte 800 realisiert ist, beträgt 33mm x 26mm. Auf dem Chip 801 ist analog zu Fig. 6 eine Steuerelektronik (nicht dargestellt) realisiert. Auf dem Chip 801 der Aperturplatte 800 sind die einzelnen Aperturzeilengruppen 804 in eine erste Aperturgruppe 810, eine zweite Aperturgruppe 820 und eine dritte Aperturgruppe 830 gegliedert. Die einzelnen Aperturzeilengruppen 804 der ersten Aperturgruppe 810, der zweiten Aperturgruppe 820 und der dritten Aperturgruppe 830 sind derart angeordnet, dass die einzelnen Aperturzeilengruppen einer jeden Aperturgruppe unmittelbar aneinander grenzen. Die einzelnen Aperturgruppen 810, 820 und 830 sind auf dem Chip voneinander durch unstrukturierte Bereiche 807 beabstandet. Die zweite Aperturgruppe 820 ist dabei derart ausgestaltet, dass um das Symmetriezentrum 809 der zweiten Aperturgruppe 820 vier Aperturzeilengruppen 804 angeordnet sind. An die vier zentralen Aperturzeilengruppen 804 schließen sich jeweils vier L-förmige Anordnungen 811 der Aperturzeilengruppen an, wobei die kurzen Schenkel des L's nach Außen weisen. Bei dem in Figur 8 dargestellten Ausführungsbeispiel, ist die Zahl k der Öffnungen in jeder Aperturzeile gleich 64. Der Abstand zwischen zwei Öffnungen innerhalb einer Zeile beträgt fünf Zellen, bzw. der Pitchabstand p ist gleich 6. Eine Aperturzeilengruppe 804 kann z.B. 64 Aperturzeilen umfassen, die in Y-Richtung um 6W versetzt sind.

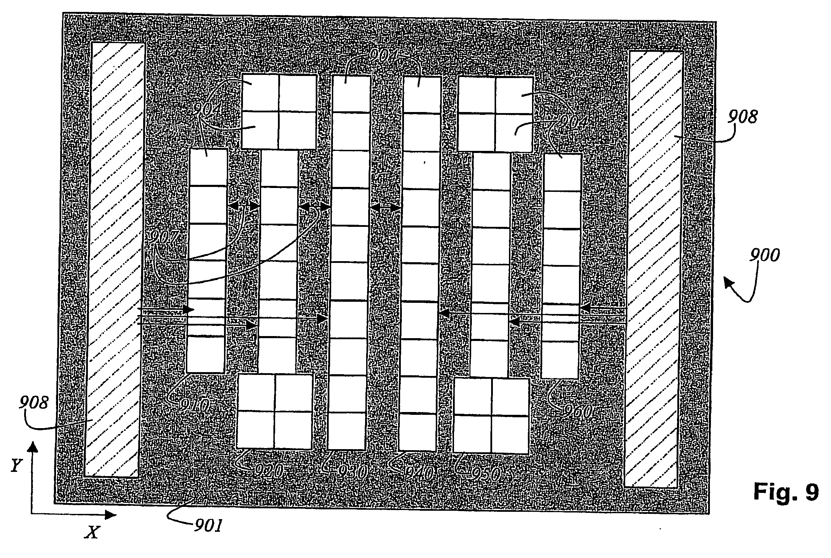

Figur 9 zeigt eine schematische Ansicht einer kompletten aktiven Aperturplatte 900 gemäß einer weiteren Ausführungsform der Erfindung. Die Größe eines Chips 901, auf dem die Aperturplatte 900 realisiert ist, beträgt 33mm x 26mm. Der Chip 901 ist symmetrisch aufgebaut und besitzt an gegenüberliegenden Seiten jeweils eine Steuerelektronik 908. Auf dem Chip 901 der Aperturplatte 900 sind die einzelnen Aperturzeilengruppen 904 in sechs Aperturgruppen 910, 920, 930, 940, 950, 960 angeordnet. Die Form der Anordnung der einzelnen Aperturgruppen 910, 920, 930, 940, 950, 960 ist im wesentlichen linear. Ebenso besitzen die einzelnen Aperturgruppen 910, 920, 930, 940, 950, 960 den gleichen Abstand 907 voneinander. Die dritte und die vierte Aperturgruppe 930, 940 haben eine Zahl H von linear angeordenten Aperturzeilen gruppen 904. Die zweite und die fünfte Aperturgruppe 920, 950 besitzen an den jeweils gegenüberliegenden Enden der linearen Anordnung der Aperturgruppe 920, 950 ein Ende aus vier quadratisch angeordneten Aperturzeilengruppen 904. Die erste und die sechste Aperturgruppe 910, 960 haben ein Zahl H von linear angeordenten Aperturzeilengruppen 904 eine Zahl H - 4 von linear angeordenten Aperturzeilengruppen 904. Bei dem in Figur 9 dargestellten Ausführungsbeispiel ist die Zahl k der Öffnungen in jeder Aperturzeile gleich 64. Der Abstand zwischen zwei Öffnungen innerhalb einer Zeile beträgt fünf Zellen, bzw. der Pitchabstand p ist gleich 6. Eine Aperturzeilengruppe 904 kann z.B. 64 Aperturzeilen umfassen, die in Y-Richtung um 6W versetzt sind.

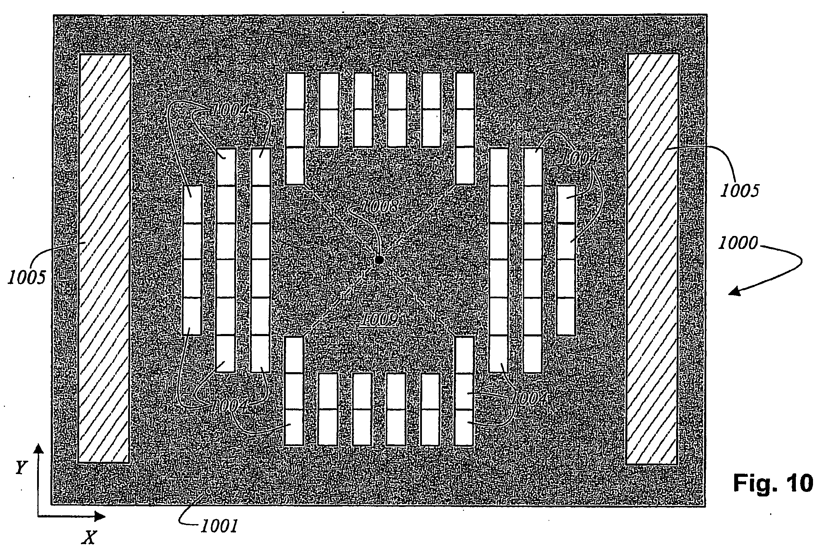

Figur 10 zeigt eine schematische Ansicht einer kompletten aktiven Aperturplatte 1000 gemäß einerweiteren Ausführungsform. Die Größe eines Chips 1001, auf dem die Aperturplatte 1000 realisiert ist, beträgt 66mm x 52mm. Auf dem Chip 1001 ist auf gegenüberliegenden Seiten eine Steuerelektronik 1005 realisiert. Auf dem Chip 1001 der aktiven Aperturplatte 1000 sind die einzelnen Aperturzeilengruppen 1004, um ein Symmetriezentrum 1008 herum angeordnet. Der Bereich 1009 um das Symmetriezentrum 1008 herum ist frei von jeglicher Strukturierung. Bei dem in Figur 10 dargestellten Ausführungsbeispiel, ist die Zahl k der Öffnungen in jeder Aperturzeile gleich 128. Der Abstand zwischen zwei Öffnungen innerhalb einer Zeile beträgt fünf Zellen, bzw. der Pitchabstand p ist gleich 6. Eine Aperturzeilengruppe 1004 kann z.B. 128 Aperturzeilen umfassen, die in Y-Richtung um 6W versetzt sind. Alle 60 dargestellten Aperturzeilengruppen 1004 zusammen beinhalten somit 7680 Aperturzeilen mit jeweils 128 Öffnungen. Aus Gründen der Datenübertragungseffektivität kann es sinnvoll sein, die Anzahl der Aperturzeilen z.B. auf 8192 zu erweitern, was durch Anordnung weiterer Aperturzeilengruppen bzw. durch Erhöhung der Anzahl der Aperturzeilen pro Aperturzeilengruppe erfolgen kann.

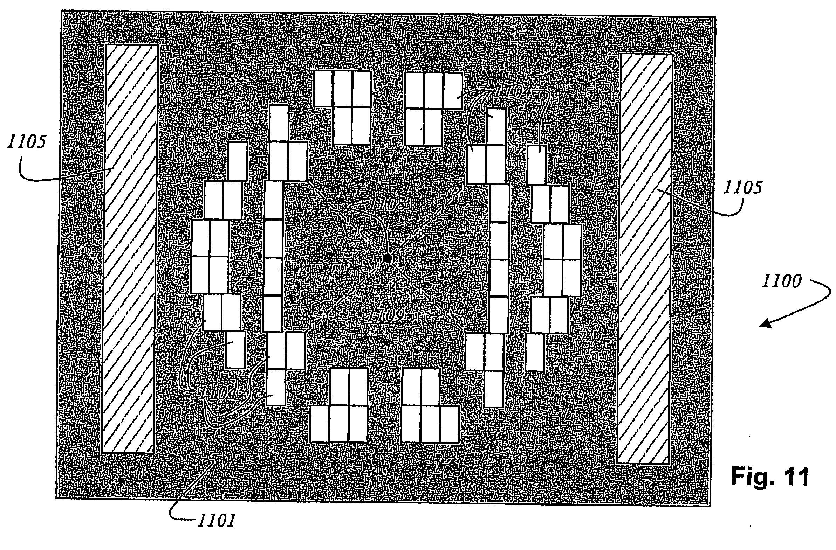

Figur 11 zeigt eine schematische Ansicht einer aktiven Aperturplatte 1100 gemäß einer weiteren Ausführungsform. Die Größe eines Chips 1101, auf dem die Aperturplatte 1100 realisiert ist, beträgt 66mm x 52mm. Auf dem Chip 1101 ist auf gegenüberliegenden Seiten eine Steuerelektronik 1105 realisiert. Auf dem Chip 1101 der Aperturplatte 1100 sind die einzelnen Aperturzeilengruppen 1104, um ein Symmetriezentrum 1108 herum angeordnet Der Bereich 1109 um das Symmetriezentrum 1108 herum ist frei von jeglicher Strukturierung. Bei dem in Figur 11 dargestellten Ausführungsbeispiel, ist die Zahl kder Öffnungen in jeder Aperturzeile gleich 128. Der Abstand zwischen zwei Öffnungen innerhalb einer Zeile beträgt fünf Zellen, bzw. der Pitchabstand p ist gleich 6. Eine Aperturzeilengruppe 1104 kann z.B. 128 Aperturzeilen umfassen, die in Y-Richtung um 6W versetzt sind.

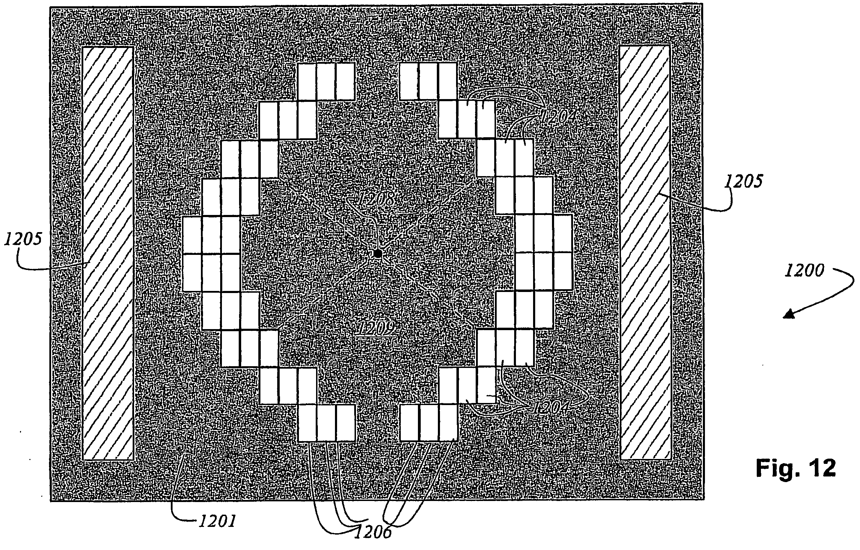

Figur 12 zeigt eine schematische Ansicht einer aktiven Aperturplatte 1200 gemäß einer weiteren Ausführungsform. Die Größe eines Chips 1201, auf dem die Aperturplatte 1200 realisiert ist, beträgt 66mm x 52mm. Auf dem Chip 1201 ist auf gegenüberliegenden Seiten eine Steuerelektronik 1205 realisiert. Auf dem Chip 1201 der Aperturplatte 1200 sind die einzelnen Aperturzeilengruppen 1204, um ein Symmetriezentrum 1208 herum angeordnet. Der Bereich 1209 um das Symmetriezentrum 1208 herum ist frei von jeglicher Strukturierung. Bei dem in Figur 12 dargestellten Ausführungsbeispiel, ist die Zahl kder Öffnungen in jederAperturzeile gleich 128. Der Abstand zwischen zwei Öffnungen innerhalb einer Zeile beträgt fünf Zellen, bzw. der Pitchabstand p ist gleich 6. Eine Aperturzeilengruppe 1204 kann z.B. 128 Aperturzeilen umfassen, die in Y-Richtung um 6W versetzt sind. Der Y-Versatz der sechs Aperturzeilengruppen innerhalb einer X-Linie 1206 beträgt auch hier zwischen 1W und 5W.

Ein weiterer wichtiger Aspekt bei der Auswahl der Position der Öffnungen in den einzelnen Aperturplatten und der Position der Aperturzeilenanfänge ist die Minimierung von Abbildungsfehlern. Aus der konventionellen Optik ist bekannt, dass diese Fehler mit zunehmendem radialen Abstand der Teilstrahlen von der Strahlachse stark ansteigen. Es ist deshalb sinnvoll, ungeachtet der rechteckigen Arraystruktur eine Konfiguration der Aperturplatte zu wählen, die Teilstrahlen in den Eckbereichen weitgehend vermeidet, wie das in den Figuren 7, 8, 9, 10, 11 und 12 in unterschiedlicher Art und Weise beispielhaft dargestellt ist. Da in der Praxis ein gewisser Mindestabstand zwischen den Modulatorelementen eingehalten werden muss und, andererseits, aus Gründen von Platzausnutzung und optischerTransparenzder Anordnung ein kompakter Aufbau zu bevorzugen ist, ergibt sich als Grundvariante eine regelmäßige Arrayanordnung, wie sie in verschiedenen Veröffentlichungen vorgeschlagen wird.

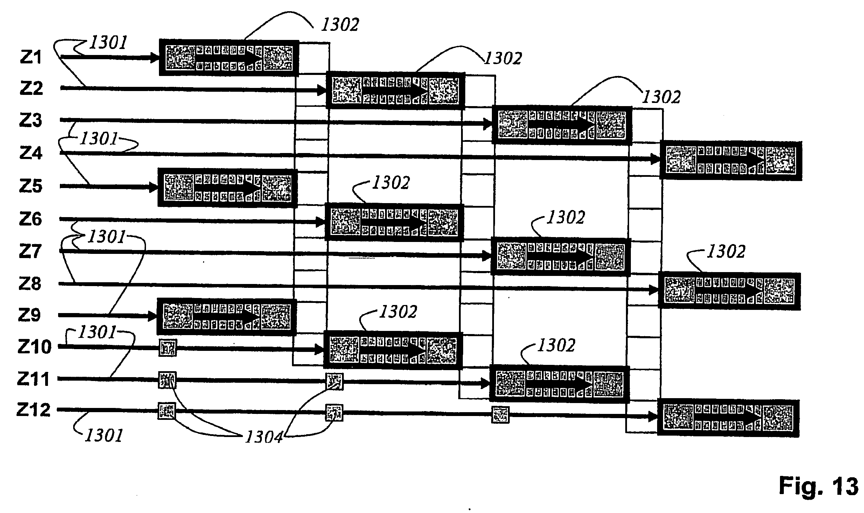

Die Ansteuerung (Zufuhr der Dosisinformation) jeder Aperturenzeile erfolgt direkt am Aperturzeilenanfang, so dass der jeweilige X-Versatz zum Zeilenanfang bzw. zur Ansteuerelektronik durch Leiterzüge überbrückt wird. Zur Sicherung der Signalqualität können wenige Schieberegister 1302 oder andere Signalformerstufen 1304 dazwischengeschaltet werden (siehe Fig. 13). Der korrekte Datenbezug kann durch entsprechende Aufbereitung der Dosisdaten und taktverzögerte Ausgabe der Zeileninformationen elektronisch hergestellt werden.

Das Schieberegisterarray m x n korrespondiert mit einem m x n großen Pixelfeld auf dem Substrat oder Traget 6. Die Datenzufuhr erfolgt über die Leitungen 1301, die eine Bitbreite b besitzen. Ebenso soll jede Schieberegisterstufe die Bitbreite b besitzen, wodurch 2^{b} verschiedenen Dosisstufen D kodiert werden können. Durch Nutzung des oben beschriebenen Scans in Zeilenrichtung, der exaktsynchron zum Schiebetakt abläuft, ist es möglich, jeder Dosisstufe D, die eine entsprechende Schiebezeile durchläuft, eine Pixelposition auf dem Substrat zuzuordnen. Da jede Aperturzeile m Schiebepositionen besitzt, ist es theoretisch möglich, mit jedem Dosiswert D sukzessive m verschiedene Modulatorelemente anzusteuern. Diese müssen jeweils so angeordnet sein, dass die zugehörigen Teilstrahlen durch die Projektionsoptik in zeitlicher Abfolge auf ein und dasselbe Substratpixel abgebildet werden - im Idealfall in regelmäßigen Abständen auf einer Linie, real auf einem Kurvenzug, der die Verzeichnungen der Abbildungsoptik kompensiert. Nun ist es aus Platzgründen unmöglich, in jeder Zeile an jeder Schiebeposition ein Modulatorelement anzuordnen; andererseits ist das auch nicht notwendig: Zur Erzielung der gewünschten Dosisstaffelung sind k (typisch 64...512) identische Modulatorelemente ausreichend: 2^{b} - 1 ≤ k < m. Damit ergibt sich unter Beachtung des Zusammenhanges zwischen Schiebestufe und Strahlposition in jeder Aperturzeile die Auswahlmöglichkeit von k Positionen aus m.

Hieraus leitet sich der Aufbau eines Multistrahlmodulators auf der Basis eines Schieberegisterarray aus n Zeilen und m Schiebestufen, wobei in jeder Zeile k Modulatorelemente wahlfrei an k von m Positionen angeordnet werden können.

In der praktischen Realisierung können alle Schiebestufen, die nach dem letzten Modulatorelement in jeder Zeile folgen würden, selbstverständlich weggelassen werden, da die Dosisstufeninformation nicht weiter benötigtwird. Auch die Schiebestufen vor dem ersten Modulatorelement einer Zeile lassen sich einsparen, wenn die Datenzufuhr mit entsprechender Taktverzögerung erfolgt.

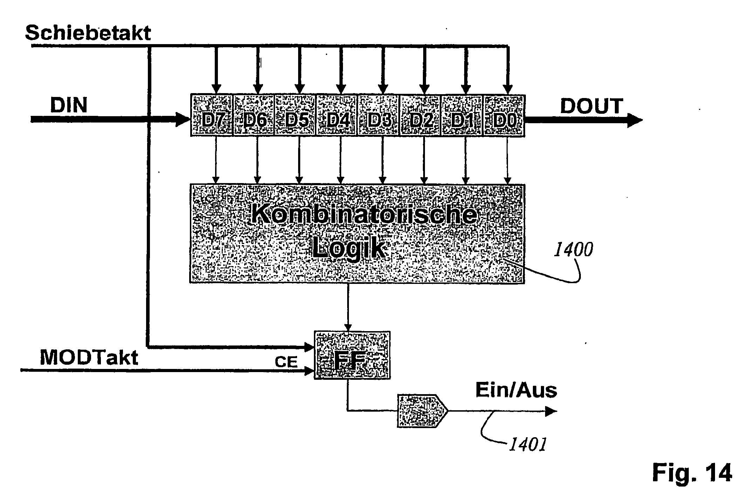

Ein weiterer Vorteil der vorgeschlagenen Erfindung besteht darin, dass nicht nur eine Ein/Aus-Information durch die Zeilen der aktiven Aperturplatte oder des Modulatorarrays geschoben wird, sondern eine Graustufeninformation mit einer Bitbreite b (typisch 6...8bit). Dadurch eröffnen sich vielfältige Möglichkeiten der Ansteuerung der Modulatorelemente. Fig. 14 zeigt einen Vorschlag, bei dem jedem Modulatorelement 1401 eine kombinatorische Logikschaltung 1400 zugeordnet ist. Durch das am Ausgang der Logikschaltung 1400 anliegenden Signals wird entschieden, ob das Modulatorelement 1401 den zugehörigen Teilstrahl ein oder ausschaltet. Auf Grundlage der anstehenden Dosisstufe D wird somit entschieden, ob zum Zeitpunkt des Übernahmetaktes MODTakt der Teilstrahl eingeschaltet wird oder nicht. Als Beispiel kann von den k Logikschaltungen der k Modulatorelemente einer Zeile genau eine bei D>0 , eine bei D>1 usw. bis genau eine bei D>k-1 als Resultat "Teilstrahl ein" liefern, womit k Dosisstufen realisiert werden können. Beliebige andere logische Verknüpfungen der Bits von D sind möglich. Der Umstand, dass die Zuordnung der Logikschaltungen zu den Modulatoren einer Zeile beliebig sein kann, ermöglicht es, eine Variante zu wählen, die eine lateral homogene Strahlverteilung bei allen Dosisstufen ergibt.

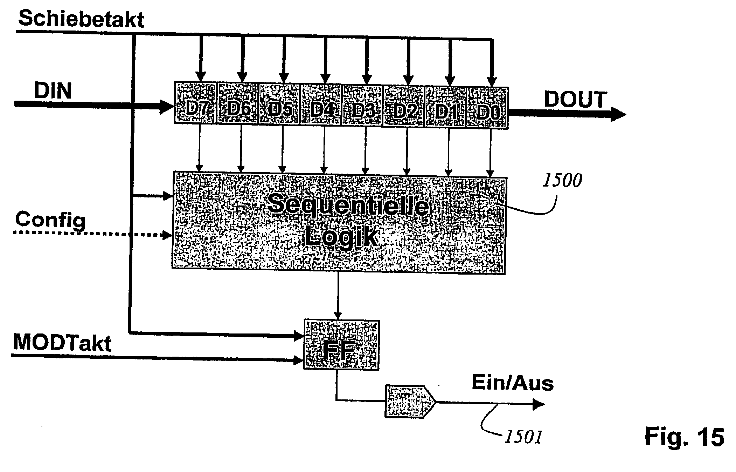

Desweiteren wird vorgeschlagen, alle bzw. einen Teil der Logikschaltungen mit s internen Speicherzellen zu versehen, wodurch aus der kombinatorischen Logik eine sequentielle Logik 1500 (von der Vorgeschichte abhängig, da mit "Gedächtnis") wird. Die Speicherzellen werden als s bit Konfigurationsspeicher genutzt, der vor der Belichtung geladen werden muss. Ist s <= b, so kann das Laden in der Weise geschehen, dass bestimmte Bits der anstehenden Dosisstufe D in die Konfiguration übernommen werden, wenn ein Konfigurationssignal Config aktiviert wird (Fig. 15). Bereits bei einem Konfigurationsbit (s = 1) ist es möglich, ein bestimmtes Modulatorelement zu aktivieren (nimmt entsprechend seiner Logik an der Teilstrahlsteuerung teil) oder zu deaktivieren (Modulator ist ständig im Zustand "aus"). Mit Vergrößerung von s ergeben sich eine Vielzahl von Möglichkeiten der Variation der Steuerlogik, wobei allerdings auch der schaltungstechnische Aufwand steigt. Durch die elektronische Rekonfigurierbarkeit des Modulators ergeben sich folgende neuartige Möglichkeiten. Es wird eine Fehlerredundanz ermöglicht, so dass bei Ausfall einzelner Modulatorelemente einfach einige bewusst als Reserve im Layout vorgesehene aktiviert werden können. Ebenso ist eine Dosisanpassung der Belichtungszeilen möglich. Dies erfolgt durch Anpassung der Zahl aktiver Modulatoren, so können Dosisschwankungen zwischen den Belichtungszeilen ausgeglichen werden (Kompensation der Ausleuchtungsinhomogenität).

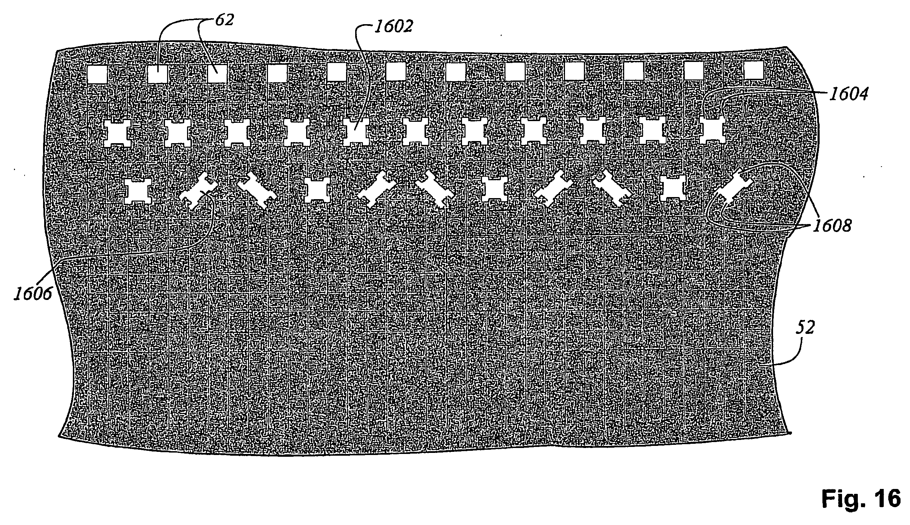

Figur 16 zeigt eine Modifikation der Geometrie der Öffnungen in der zweiten Aperturplatte 52. Die regulären, quadratischen Öffnungen 62 sind nicht modifiziert. Bei der Herstellung der Öffnungen in der Aperturplatte können Eckenverrundungen zu einer Deformation des Querschnitts des Teilstrahls führen. Eine definierte Vorverzerrung der Geometrie der Öffnungen in der Aperturplatte 52 kann dies teilweise kompensieren. Fig. 16 zeigt dazu einfache Beispiele zur Modifikation der Geometrie der Öffnungen. In einer ersten Variante besitzen die Öffnungen 1602 einen quadratischen Querschnitt, wobei an den Ecken des Quadrats jeweils eine weitere kleine Öffnung 1604 ausgebildet ist. Die gesamte Geometrie des Querschnitts der Öffnung erstreckt sich über die Dimension einer Zelle der Aperturplatte 52. Eine weitere Möglichkeit der Ausgestaltung einer Modifikation einer Öffnung 1606 in der Aperturplatte ist, dass die Öffnung 1606 ein diagonal bezüglich einer Zelle ausgerichtetes Rechteck ist. Dabei sind an den Ecken des Rechtecks weitere rechteckige kleine Öffnungen 1608 ausgebildet. Wie in Figur 16 dargestellt ist, können sich die Öffnungen hinsichtlich ihrer Form innerhalb einer Zeile ändern. Die oben erwähnte Konfigurierbarkeit der Modulatorelemente innerhalb einer Aperturzeile auf der aktiven Aperturplatte ermöglicht nun, in Abhängigkeit von der besonderen Spezifik der Belichtungsaufgabe, einzelne besonders gut geeignete Teilstrahlquerschnitte 1606 zu aktivieren und andere weniger geeignete zu deaktivieren. Die beispielhaft gezeigten 45deg bzw. 135deg gedrehten rechteckigen Strahlquerschnitte könnten helfen, die Kantenrauhigkeit bei der Belichtung von schrägen Linien zu reduzieren. Ebenso kann man sich spezielle Teilstrahlquerschnitte zur Belichtungsoptimierung für beliebig gekrümmte Strukturen oder Sonderstrukturen vorstellen.

achtzehn Zellen versetzt sind. Eine Aperturzeilensubgruppe 407 umfasst drei Aperturzeilen 406. Aperturzeilengruppen 408 werden durch eine Vielzahl von in Y-Richtung aneinander grenzender Aperturzeilensubgruppen 407 gebildet. In X-Richtung benachbarte Aperturzeilen 406 gehören stets zu verschiedenen Aperturzeilengruppen und besitzen einen Y-Versatz von wenigstens einer Zelle.
Figur 5 zeigt eine zweite Ausführungsform der Aperturplatte 500 gemäß der Erfindung. Die Öffnungen 503 in der Aperturplatte 500 sind nach dem erfindungsgemäßen System verteilt. In der Aperturplatte 500 sind n Zeilen 501 mit m Zellen und m Spalten 502 mit n Zellen ausgebildet. In jeder Zeile 501 ist eine bestimmte Anzahl k Öffnungen 503 ausgebildet. Die Öffnungen 503 sind innerhalb einer Zeile derart Verteilt, dass die Dichte der Öffnungen 503 innerhalb einer Zeile 501 ungleichmäßig verteilt ist. In dem hier dargestellten Ausführungsbeispiel sind die Öffnungen 503 innerhalb einer Zeile 501 derart gruppiert, dass der Abstand zwischen den Öffnungen 503 in einer Zeile 501 zwei Zellen beträgt. Die Zahl der Öffnungen 503 in einer Zeile 501 ist vier. Dabei ist die Zahl der Zellen innerhalb einer Zeile 501 um den Faktor mindestens zehn größer als die Zahl der Öffnungen 503. Die vier Öffnungen 503 sind derart verteilt, dass jede dritte Zelle eine Öffnung 503 ist. Der Aperturzeilenversatz 504 beträgt in X-Richtung fünfzehn Zellen, d.h., dass jeweils zwei benachbarte Aperturzeilensubgruppen 505, 507 um fünfzehn Zellen in X-Richtung versetzt sind. In dem hier dargestellten Ausführungsbeispiel wechseln eine erste Aperturzeilensubgruppe 505 und eine zweite Apertuzeilensubgruppe 507 einander ab. Sowohl die erste als auch die zweite Aperturzeilensubgruppe 505 und 507 umfasst drei Aperturzeilen 506. Die erste Aperturzeilensubgruppe 505 ist dabei derart ausgestaltet, dass die erste Zeile 501 der ersten Aperturzeilensubgruppe 505 mit einer Öffnung 503 beginnt. Die zweite Aperturzeilensubgruppe 507 ist dabei derart ausgestaltet, dass die erste Zeile 501 bei der dritten Zelle mit einer Öffnung 503 beginnt.
Die oben erläuterten Realisierungsvarianten sind auf der Basis der vorgeschlagenen Verteilung der Öffnungen 403, 503 folglich auch der Der Erfindung liegt die Aufgabe zugrunde, Multistrahlmodulatoren für einen Partikelstrahl zur maskenlosen Übertragung eines Layouts auf ein Substrat zu schaffen, die direkt elektronisch angesteuert werden können, und wobei der Multistrahlmodulator sowohl hinsichtlich des minimalen Speicherbedarfs der elektronischen Schaltung, als auch der zeitlichen und räumlichen Homogenisierung des Gesamtstrahls sowie strahloptischer Gesichtspunkte konfigurierbar ist.
Diese Aufgabe wird durch einen Multistrahlmodulator mit den Merkmalen des Anspruchs 1 gelöst.
Eine weitere Aufgabe der Erfindung ist die Verwendung des Multistrahlmodulators zur maskenlosen Substratstrukturierung, wobei der Multistrahlmodulator sowohl hinsichtlich des minimalen Speicherbedarfs der elektronischen Schaltung, als auch der zeitlichen und räumlichen Homogenisierung des Gesamtstrahls sowie strahloptischer Gesichtspunkte konfigurierbar ist.
Diese Aufgabe wird durch einen Multistrahlmodulator mit den Merkmalen des Anspruchs 21 gelöst.
Die Erfindung hat den Vorteil, dass dadurch die aufwändigen und kostenintensiven Schritte der Herstellung von Belichtungsmasken vermieden werden. Das zeitlich serielle Schreibprinzip bedingt jedoch eine gegenüber der parallelen Strukturübertragung mittels Maske verringerte Produktivität der Belichtung. Eine Entwicklungsrichtung maskenloser Belichtungsgeräte besteht deshalb darin, durch eine große Anzahl parallel arbeitender Teilstrahlen die effektive Schreibgeschwindigkeit zu vervielfachen. Die Teilstrahlen sind dabei in Form eines Arrays angeordnet und können durch ein spezielles Modulationselement (steuerbare Strahlquellen / Blanker / Spiegel) einzeln ein- und ausgeschaltet werden. Der vorliegende Erfindungsvorschlag beschreibt den Aufbau eines Multistrahlmodulators auf der Basis von zeilenorientierten Schieberegistern und dessen Konzept der Dosissteuerung.
Dabei kann der Multistrahlmodulator sowohl hinsichtlich minimalen Speicherbedarfs der elektronischen Schaltung, als auch der zeitlichen und formdefinierte Teilstrahl 80 trifft auf die dritte Aperturplatte 53, in der Öffnungen 63 ausgebildet sind, die ebenfalls eine größere Abmessung 73 aufweisen als die Öffnungen 62 in der zweiten Aperturplatte 52. Die dritte Aperturplatte 53 weist auf der dem einfallenden Partikelstrahl 31 abgewandten Seite eine Ansteuerschaltung 55 auf, die die für die Ablenkung des formdefinierten Teilstrahl 80 erforderlichen Signale erzeugt. Die dritte Aperturplatte 53 besitzt eine Dicke 53_{D} von circa 20µm bis 100 µm. Die vierte Aperturplatte 54 besitzt eine Dicke 54_{D} von circa 20µm bis 100 µm.
Ebenso ist an der dem einfallenden Partikelstrahl 31 abgewandten Seite der dritten Aperturplatte 53 jede Öffnung 63 ein Deflektor 56 für den formdefinierten Teilstrahl 80 zugeordnet. Der dritten Aperturplatte 53 ist eine vierte Aperturplatte 54 nachgeschaltet, in der ebenso Öffnungen 64 vorgesehen sind, die in etwa die gleiche Abmessung 74 aufweisen wie die Öffnungen 63 in der dritten Aperturplatte 53. Die erste Aperturplatte 51, die zweite Aperturplatte 52, die dritte Aperturplatte 53 und die vierte Aperturplatte 54 sind zueinander derart angeordnet, dass alle Öffnungen 61, 62, 63, 64 entlang einer Zentrumsachse 81 ausgerichtet sind.
Figur 4 zeigt eine erste Ausführungsform der Aperturplatte 400 gemäß der Erfindung. Die Öffnungen 403 in der Aperturplatte 400 sind nach dem erfindungsgemäßen System verteilt. In der Aperturplatte 400 sind n Zeilen 401 mit m Zellen und m Spalten 402 mit n Zellen ausgebildet. In jeder Zeile 401 ist eine bestimmte Anzahl k Öffnungen 403 ausgebildet. Die Öffnungen 403 sind innerhalb einer Zeile derart Verteilt, dass die Dichte der Öffnungen 403 innerhalb einer Zeile 401 ungleichmäßig verteilt ist. In dem hier dargestellten Ausführungsbeispiel sind die Öffnungen 403 innerhalb einer Zeile 401 derart gruppiert, dass der Abstand zwischen den Öffnungen 403 in einer Zeile 401 zwei Zellen beträgt. Die Zahl der Öffnungen 403 in einer Zeile 401 ist vier. Dabei ist die Zahl der Zellen innerhalb einer Zeile 401 um den Faktor mindestens zehn größer als die Zahl der Öffnungen 403. Die vier Öffnungen 403 sind derart verteilt, dass jede dritte Zelle eine Öffnung 403 ist. Der Aperturzeilenversatz 404 beträgt achtzehn Zellen in X-Richtung, d.h., dass jeweils zwei in X-Richtung nebeneinander liegende Aperturzeilen 406 um

## Patentansprüche

1. Multistrahlmodulator, der aus einem Partikelstrahl, von dem der Multistrahlmodulator zumindest teilweise flächig beleuchtet ist, mehrere individuell steuerbare Teilstrahlen erzeugt und mindestens eine Aperturplatte aufweist mit einer Vielzahl von Öffnungen, die in einer Matrix aus m x n Zellen definiert angeordnet sind, wobei in jeder Zeile aus m Zellen eine Anzahl k von Öffnungen ausgebildet ist, **dadurch gekennzeichnet, dass**
- in jeder Zeile (401, 501) die Öffnungen (403, 503), deren Anzahl k ist, in möglichst geringem Abstand hintereinander angeordnet sind und dadurch innerhalb jeder Zeile (401, 501) eine Aperturzeile (406, 506), gebildet durch alle Öffnungen (403, 503) einer Zeile (401, 501) nebst dazwischen liegenden Zellen, mit geringst möglicher Aperturzeilenlänge ausgebildet ist, sodass die Dichte der Öffnungen (403, 503) innerhalb einer Zeile (401, 501) ungleichmäßig verteilt ist, wobei
- die Öffnungen (403, 503) innerhalb der Aperturzeile (406, 506) gleich beabstandet sind mit einem Abstand, der gleich einem ganzzahligen Vielfachen der Zellengröße der Matrix ist, und die Zahl m der Zellen einer Zeile (401, 501) um einen Faktor von mindestens 10 größer als die Anzahl k der Öffnungen (403, 503) der Aperturzeile (406, 506) ist und der Abstand zwischen den Öffnungen (403, 503) gemessen in Zellen kleiner ist als der Quotient aus der Zahl m der Zellen einer Zeile (401, 501) und der Anzahl k der Öffnungen (403, 503) innerhalb einer Aperturzeile (406, 506), und außerhalb der Aperturzeile (406, 506) in jeder Zeile (401, 501) keine Öffnungen (403, 503) vorhanden sind.

2. Multistrahlmodulator nach Anspruch 1, **dadurch gekennzeichnet, dass** die Zahl k der Öffnungen innerhalb einer Zeile zwischen 64 und 512 beträgt.

3. Multistrahlmodulator nach einem der Ansprüche 1 bis 2, **dadurch gekennzeichnet, dass** die Zahl m der Zellen in einer Zeile 4096 beträgt.

4. Multistrahlmodulator nach einem der Ansprüche 1 bis 3, **dadurch gekennzeichnet, dass** zwischen den Öffnungen innerhalb einer Zeile 3 bis 7 Zellen vorgesehen sind.

5. Multistrahlmodulator nach einem der Ansprüche 1 bis 4, **dadurch gekennzeichnet, dass** die Zellen eine quadratische Form besitzen und einem auf ein Target (6) zu schreibendem Pixel entsprechen.

6. Multistrahlmodulator nach einem der Ansprüche 1 bis 5, **dadurch gekennzeichnet, dass** mehrere Aperturzeilen zu Aperturzeilensubgruppen zusammengefasst sind und mehrere Aperturzeilensubgruppen eine Aperturzeilengruppe bilden.

7. Multistrahlmodulator nach Anspruch 6, **dadurch gekennzeichnet, dass** sechs Aperturzeilen zu Aperturzeilensubgruppen zusammengefasst sind.

8. Multistrahlmodulator nach Anspruch 7, **dadurch gekennzeichnet, dass** in Zeilenrichtung benachbarte Aperturzeilengruppen um jeweils 684 Zellen in Zeilenrichtung sowie 1 bis 5 Zellen orthogonal zur Zeilenrichtung versetzt sind.

9. Multistrahlmodulator nach Anspruch 7, **dadurch gekennzeichnet, dass** die Aperturzeilengruppen unregelmäßig versetzt sind.

10. Multistrahlmodulator nach den Ansprüchen 1 bis 9, **dadurch gekennzeichnet, dass** mehrere Aperturzeilengruppen zu Aperturgruppen zusammengefasst sind und regelmäßig auf einem Chip einer Aperturplatte angeordnet sind.

11. Multistrahlmodulator nach Anspruch 10, **dadurch gekennzeichnet, dass** die Aperturgruppen durch Stege getrennt sind, auf denen keine Strukturierung durch Aperturen vorgenommen ist.

12. Multistrahlmodulator nach Anspruch 11, **dadurch gekennzeichnet, dass** die Stege parallel sind.

13. Multistrahlmodulator nach Anspruch 10, **dadurch gekennzeichnet, dass** die Aperturgruppen symmetrisch um ein Zentrum angeordnet sind.

14. Multistrahlmodulator nach einem der Ansprüche 1 bis 13, **dadurch gekennzeichnet, dass** mindestens eine elektronische Schaltung auf der aktiven Aperturplatte strukturiert ist.

15. Multistrahlmodulator nach Anspruch 14, **dadurch gekennzeichnet, dass** wenigstens eine elektronische Schaltung die auf der Aperturplatte ausgebildeten Schieberegister mit Daten versorgt.

16. Multistrahlmodulator nach Anspruch 15, **dadurch gekennzeichnet, dass** jeder Aperturzeile eine Schieberegisterkette zugeordnet ist, welche von der ersten bis zur letzten Aperturöffnung jeder Aperturzeile ein synchrones Durchschieben der eingespeisten Daten von Zelle zu Zelle gewährleistet.

17. Multistrahlmodulator nach Anspruch 16, **dadurch gekennzeichnet, dass** über die Schieberegister an die Modulatorelemente des Multistrahlmodulators eine Graustufeninformation der Bitbreite 1 bis b bereitgestellt wird, wobei b zwischen 6bit und 8bit liegt.

18. Multistrahlmodulator nach Anspruch 17, **dadurch gekennzeichnet, dass** zusätzlich zu den Schieberegistern der Aperturzeilen pro Apertur eine kombinatorische Logikschaltung zur Gewinnung des Ein-/Aus -Signals aus der Graustufeninformation vorhanden ist.

19. Multistrahlmodulator nach Anspruch 17, **dadurch gekennzeichnet, dass** zusätzlich zu den Schieberegistern der Aperturzeilen pro Apertur eine sequentielle Logikschaltung zur Gewinnung des Ein-/Aus -Signals aus der Graustufeninformation vorhanden ist.

20. Multistrahlmodulator nach Anspruch 19, **dadurch gekennzeichnet, dass** zur Programmierung der sequentiellen Logikschaltung die Schieberegister der Graustufeninformation verwendet wird und zusätzlich ein geeignetes "Config" Signalnetz implementiert ist.

21. Verwendung eines Multistrahlmodulators zur maskenlosen Substratstrukturierung, wobei aus einem Partikelstrahl, der den Multistrahlmodulator zumindest teilweise flächig beleuchtet, mehrere Partikelteilstrahlen mittels mindestens einer Aperturplatte (34; 51, 52, 53, 54) erzeugt werden, wobei im Multistrahlmodulator (34, 35; 50) in der mindestens einen Aperturplatte (34; 51, 52, 53, 54; 600, 700, 800, 900, 1000, 1100, 1200) Öffnungen (403, 503) ausgebildet sind, die in einer Matrix aus m x n Zellen definiert angeordnet sind, wobei in jeder aus m Zellen bestehenden Zeile (401, 501) eine definierte Anzahl k von Öffnungen (403, 503) in möglichst geringem Abstand hintereinander angeordnet ist und innerhalb jeder Zeile eine Aperturzeile (406, 506), gebildet durch alle Öffnungen (403, 503) einer Zeile (401, 501) nebst dazwischen liegenden Zellen, mit geringst möglicher Aperturzeilenlänge (401, 501) derart ausgebildet ist, dass die Öffnungen (403 503) innerhalb der Aperturzeile (406, 506) gleich beabstandet sind, mit einem Abstand, der gleich einem ganzzahligen Vielfachen der Zellengröße der Matrix ist, und die Zahl m der Zellen einer Zeile (401, 501) um einen Faktor von mindestens 10 größer als die Anzahl k der Öffnungen (403, 503) der Aperturzeile (406, 506) ist und der Abstand zwischen den Öffnungen (403, 503) gemessen in Zellen kleiner ist als der Quotient aus der Zahl m der Zellen einer Zeile (401, 501) und der Anzahl k der Öffnungen (403, 503) innerhalb einer Aperturzeile (406, 506), und außerhalb der Aperturzeile (406, 506) in der Zeile (401, 501) keine Öffnungen (403, 503) vorhanden sind, wobei mittels der durch die Öffnungen (403, 503) einer Aperturzeile (406, 506) individuell beeinflussbaren Partikelteilstrahlen eine Steuerung der Belichtungsdosis für ein jeweils bei der Substratstrukturierung zu belichtendes Pixel ermöglicht wird.

## Claims

1. A multibeam modulator which generates a plurality of individually controllable beams from a particle beam, the particle beam illuminating said multibeam modulator in an at least partially plane manner, said multibeam modulator comprising at least one aperture plate with a plurality of openings arranged in a defined manner in a matrix of m x n cells, each row of m cells comprising a number k of openings formed therein, **characterised in that**
- the openings (403, 503), whose number is k, are sequentially arranged in each row (401, 501) with a minimal space between them and that thereby, within each row (401, 501), an aperture row (406, 506), formed by all the openings (403, 503) of a row (401, 501) together with the cells therebetween, with a minimal aperture row length is formed so that the density of the openings (403, 503) within a row (401, 501) is inhomogeneously distributed, wherein
- the openings (403, 503) within the aperture row (406, 506) are equally spaced apart by a distance equal to an integer multiple of the cell size of the matrix, and the number m of the cells of a row (401, 501) is greater than the number k of the openings (403, 503) of the aperture row (406, 506) by a factor of at least 10, and the distance between the openings (403, 503), measured in cells, is less than the quotient of the number m of cells within a row (401, 501) and the number k of openings (403, 503) within an aperture row (406, 506), and there are no openings (403, 503) outside the aperture row (406, 506) within each row (401, 501).

2. The multibeam modulator according to claim 1, **characterised in that** the number k of openings within a row is between 64 and 512.

3. The multibeam modulator according to any one of claims 1 to 2, **characterised in that** the number m of cells in a row is 4096.

4. The multibeam modulator according to any one of claims 1 to 3, **characterised in that** 3 to 7 cells are provided between the openings within a row.

5. The multibeam modulator according to any one of claims 1 to 4, **characterised in that** the cells have a square shape and correspond to a pixel to be written on a target (6).

6. The multibeam modulator according to any one of claims 1 to 5, **characterised in that** a plurality of aperture rows combine to form aperture row subgroups and a plurality of aperture row subgroups form an aperture row group.

7. The multibeam modulator according to claim 6, **characterised in that** six aperture rows combine to form aperture row subgroups.

8. The multibeam modulator according to claim 7, **characterised in that** neighbouring aperture row groups in row direction are offset in each instance by 684 cells in row direction and 1 to 5 cells orthogonal to the row direction.

9. The multibeam modulator according to claim 7, **characterised in that** the aperture row groups are offset inhomogeneously.

10. The multibeam modulator according to claims 1 to 9, **characterised in that** a plurality of aperture row groups combine to form aperture groups and are uniformly arranged on a chip of an aperture plate.

11. The multibeam modulator according to claim 10, **characterised in that** the aperture groups are separated by webs on which no structuring with apertures is carried out.

12. The multibeam modulator according to claim 11, **characterised in that** the webs are parallel.

13. The multibeam modulator according to claim 10, **characterised in that** the aperture groups are arranged symmetrically around a centre.

14. The multibeam modulator according to any one of claims 1 to 13, **characterised in that** at least one electronic circuit is structured on the active aperture plate.

15. The multibeam modulator according to claim 14, **characterised in that** at least one electronic circuit supplies data to the shift registers formed on the aperture plate.

16. The multibeam modulator according to claim 15, **characterised in that** a shift register chain is associated with each aperture row, which shift register chain provides for a synchronous shifting of the input data from cell to cell from the first aperture opening to the final aperture opening of each aperture row.

17. The multibeam modulator according to claim 16, **characterised in that** greyscale information of bit width 1 to b is provided to the modulator elements of the multibeam modulator by the shift registers, where b is between 6 bits and 8 bits.

18. The multibeam modulator according to claim 17, **characterised in that** a combination logic is provided in addition to the shift registers of the aperture rows per aperture to obtain the on/off signal from the greyscale information.

19. The multibeam modulator according to claim 17, **characterised in that** a sequential logic is provided in addition to the shift registers of the aperture rows per aperture to obtain the on/off signal from the greyscale information.

20. The multibeam modulator according to claim 19, **characterised in that** the shift registers of the greyscale information are used for programming the sequential logic and a suitable "Config" signal network is implemented in addition.

21. Use of a multibeam modulator for maskless structuring of substrates, wherein a plurality of individual particle beams are generated, by means of at least one aperture plate (34; 51, 52, 53, 54), from a particle beam which illuminates the multibeam modulator in an at least partially plane manner, wherein openings (403, 503) are formed in the multibeam modulator (34, 35; 50) in the at least one aperture plate (34; 51, 52, 53, 54; 600, 700, 800, 900, 1000, 1100, 1200), said openings being arranged in a defined manner in a matrix of m x n cells, wherein a defined number k of openings (403, 503) are sequentially arranged within each row (401, 501) of m cells with a minimal space between them and wherein an aperture row (406, 506), formed by all the openings (403, 503) of a row (401, 501) together with the cells therebetween, with a minimal aperture row length is formed within each row (401, 501) so that the openings (403, 503) within the aperture row (406, 506) are equally spaced apart by a distance equal to an integer multiple of the cell size of the matrix, and the number m of the cells of a row (401, 501) is greater than the number k of the openings (403, 503) of the aperture row (406, 506) by a factor of at least 10, and the distance between the openings (403, 503), measured in cells, is less than the quotient of the number m of cells within a row (401, 501) and the number k of openings (403, 503) within an aperture row (406, 506), and there are no openings (403, 503) outside the aperture row (406, 506) within the row (401, 501), wherein the individual particle beams, which can be influenced individually by the openings (403, 503) of an aperture row (406, 506), enable control of the dose of exposure for each pixel to be exposed when structuring substrates.

## Revendications

1. Modulateur multifaisceaux qui engendre, à partir d'un faisceau de particules illuminant le modulateur multifaisceaux de manière au moins partiellement plane, une multitude de faisceaux individuels réglables de manière individuelle et qui comprend au moins une plaque d'aperture avec une multitude d'ouvertures disposées d'une manière définie dans une matrice constituée de m x n cellules, un nombre k d'ouvertures étant réalisé dans chaque ligne de m cellules, **caractérisé en ce que**
- les ouvertures (403, 503), dont le nombre est k, sont disposées consécutivement, les unes à une distance minimale des autres, dans chaque ligne (401, 501) et **en ce qu'**ainsi une ligne d'aperture (406, 506), formée par toutes les ouvertures (403, 503) d'une ligne (401, 501) avec les cellules entre les ouvertures (403, 503), ayant une longueur de ligne d'aperture minimale est réalisée dans chaque ligne (401, 501) de sorte que la densité des ouvertures (403, 503) dans une ligne (401, 501) soit distribuée de manière irrégulière,
- les ouvertures (403, 503) dans la ligne d'aperture (406, 506) étant disposées de manière équidistante, la distance entre elles correspondant à un multiple entier des dimensions d'une cellule de la matrice, et le nombre m de cellules d'une ligne (401, 501) étant plus grand que le nombre k des ouvertures (403, 503) de la ligne d'aperture (406, 506) d'un facteur d'au moins 10, et la distance entre les ouvertures (403, 503), mesurée en cellules, étant inférieure au quotient du nombre m de cellules par ligne (401, 501) et du nombre k d'ouvertures (403, 503) dans une ligne d'aperture (406, 506), et il n'y a pas d'ouvertures (403, 503) en dehors de la ligne d'aperture (406, 506) dans chaque ligne (401, 501).

2. Modulateur multifaisceaux selon la revendication 1, **caractérisé en ce que** le nombre k d'ouvertures dans une ligne est d'entre 64 et 512.

3. Modulateur multifaisceaux selon l'une quelconque des revendications 1 à 2, **caractérisé en ce que** le nombre m de cellules dans une ligne est de 4096.

4. Modulateur multifaisceaux selon l'une quelconque des revendications 1 à 3, **caractérisé en ce que** l'on prévoit 3 à 7 cellules entre les ouvertures dans une ligne.

5. Modulateur multifaisceaux selon l'une quelconque des revendications 1 à 4, **caractérisé en ce que** les cellules présentent une forme quadratique et correspondent à un pixel à écrire sur un objet (6).

6. Modulateur multifaisceaux selon l'une quelconque des revendications 1 à 5, **caractérisé en ce qu'**une multitude de lignes d'aperture est réunie afin de constituer des sous-groupes de lignes d'aperture et une multitude de sous-groupes de lignes d'aperture constitue un groupe de lignes d'aperture.

7. Modulateur multifaisceaux selon la revendication 6, **caractérisé en ce que** six lignes d'aperture sont réunies afin de constituer des sous-groupes de lignes d'aperture.

8. Modulateur multifaisceaux selon la revendication 7, **caractérisé en ce que** des groupes de lignes d'aperture adjacents en direction de ligne sont décalés à chaque fois de 684 cellules en direction de ligne et de 1 à 5 cellules orthogonalement à la direction de ligne.

9. Modulateur multifaisceaux selon la revendication 7, **caractérisé en ce que** les groupes de lignes d'aperture sont décalés de manière irrégulière.

10. Modulateur multifaisceaux selon les revendications 1 à 9, **caractérisé en ce qu'**une multitude de groupes de lignes d'aperture est réunie de manière à constituer des groupes d'aperture et disposée de manière régulière sur une puce d'une plaque d'aperture.

11. Modulateur multifaisceaux selon la revendication 10, **caractérisé en ce que** les groupes d'aperture sont séparés les uns des autres par des âmes sur lesquelles il n'y a pas de structuration par des apertures.

12. Modulateur multifaisceaux selon la revendication 11, **caractérisé en ce que** les âmes sont parallèles.

13. Modulateur multifaisceaux selon la revendication 10, **caractérisé en ce que** les groupes d'aperture sont disposés de manière symétrique autour d'un centre.

14. Modulateur multifaisceaux selon l'une quelconque des revendications 1 à 13, **caractérisé en ce qu'**au moins un circuit électronique est structuré sur la plaque d'aperture active.

15. Modulateur multifaisceaux selon la revendication 14, **caractérisé en ce qu'**au moins un circuit électronique fournit des données aux registres à décalage réalisés sur la plaque d'aperture.

16. Modulateur multifaisceaux selon la revendication 15, **caractérisé en ce qu'**une chaîne de registres à décalage est associée avec chaque ligne d'aperture, ladite chaîne de registres à décalage assurant un décalage synchrone des données d'entrée, de cellule en cellule à partir de la première ouverture d'aperture jusqu'à la dernière ouverture d'aperture de chaque ligne d'aperture.

17. Modulateur multifaisceaux selon la revendication 16, **caractérisé en ce que** de l'information d'échelle de gris d'une largeur de bit de 1 à b est fourni aux éléments modulateurs du modulateur multifaisceaux par les registres à décalage, où b est d'entre 6 bits et 8 bits.

18. Modulateur multifaisceaux selon la revendication 17, **caractérisé en ce qu'**il y a, en plus desdits registres à décalage des lignes d'aperture, un circuit logique combinatoire par aperture pour obtenir un signal tout ou rien à partir de l'information d'échelle de gris.

19. Modulateur multifaisceaux selon la revendication 17, **caractérisé en ce qu'**il y a, en plus desdits registres à décalage des lignes d'aperture, un circuit de logique séquentiel par aperture pour obtenir le signal tout ou rien à partir de l'information d'échelle de gris.

20. Modulateur multifaisceaux selon la revendication 19, **caractérisé en ce que** l'on utilise les registres à décalage contenant l'information d'échelle de gris pour programmer le circuit logique séquentiel et **en ce qu'**un réseau de signalisation « Config » approprié est implémenté en plus.

21. Utilisation d'un modulateur multifaisceaux pour la structuration de substrats sans masque, comprenant les étapes d'engendrer une multitude de faisceaux de particules individuels, au moyen d'au moins une plaque d'aperture (34; 51, 52, 53, 54), à partir d'un faisceau de particules illuminant ledit modulateur multifaisceaux de manière au moins partiellement plane, des ouvertures (403, 503) étant réalisées dans le modulateur multifaisceaux (34, 35; 50) dans ladite au moins une plaque d'aperture (34; 51, 52, 53, 54; 600, 700, 800, 900, 1000, 1100, 1200), lesdites ouvertures étant disposées de manière définie dans une matrice de m x n cellules, dans laquelle un nombre défini k d'ouvertures (403, 503) sont disposées consécutivement, les unes à une distance minimale des autres, dans chaque ligne (401, 501) de m cellules, et de réaliser dans chaque ligne (401, 501) une ligne d'aperture (406, 506), formée par toutes les ouvertures (403, 503) d'une ligne (401, 501) avec les cellules entre les ouvertures (403, 503), ayant une longueur de ligne d'aperture minimale de sorte que les ouvertures (403, 503) dans la ligne d'aperture (406, 506) soient disposées de manière équidistante, la distance entre elles correspondant à un multiple entier des dimensions d'une cellule de la matrice, et que le nombre m des cellules d'une ligne (401, 501) soit plus grand que le nombre k des ouvertures (403, 503) de la ligne d'aperture (406, 506) d'un facteur d'au moins 10, et que la distance entre les ouvertures (403, 503), mesurée en cellules, soit inférieure au quotient du nombre m de cellules par ligne (401, 501) et du nombre k d'ouvertures (403, 503) dans une ligne d'aperture (406, 506), et qu'il n'y ait pas d'ouvertures (403, 503) en dehors de la ligne d'aperture (406, 506) dans la ligne (401, 501), les faisceaux de particules individuels, que l'on peut influencer individuellement par les ouvertures (403, 503) de chaque ligne d'aperture (406, 506), permettant de régler la dose d'exposition pour chaque pixel à exposer lors de la structuration d'un substrat.
